# EUROPEAN PATENT APPLICATION

(11) **EP 0 926 825 A2**
(43) Date of publication of application: **30.06.1999**
(21) Application number: 98124596.2
(22) Date of filing: 23.12.1998
(51) Int. Cl.: H03K 3/356, H03K 19/017

(54) **Static latch circuit and static logic circuit**

(30) Priority: 24.12.1997 JP 35481897; 17.08.1998 JP 23063498
(71) Applicant: NEC CORPORATION, Tokyo (JP)
(72) Inventor: Kanno, Hiroshi, Minato-ku, Tokyo (JP)
(74) Representative: Glawe, Delfs, Moll & Partner

(57) **Abstract**

A static latch circuit and a static logic circuit can be easily designed without gate width and gate length optimization while using transistors with the smallest usable gate width to reduce power consumption. The resulting static latch circuit and static logic circuit can be used in applications where all gate lengths must be the same. The drive capacity of parts associated with the static holding function of the latch circuit and logic circuit is reduced by using a step-down circuit and step-up circuit to reduce the effective supply voltage during operation.

## Description

### BACKGROUND OF THE INVENTION

### Field of the Invention

The present invention relates generally to a static latch circuit, and more particularly to a static latch circuit achieved by adding a holding circuit to a dynamic latch circuit.

The present invention also relates generally to a static logic circuit, and more particularly to a static logic circuit achieved by adding a holding circuit to a dynamic logic circuit.

### Description of the Related Art

Dynamic circuits not comprising a static holding circuit are used in high speed circuits manufactured with CMOS technologies. A transfer gate in such a dynamic circuit typically comprises a P-channel MOS transistor and an N-channel MOS transistor where the source of the P-channel MOS transistor is connected to an input terminal, the drain is connected to an output terminal, and the gate is connected to a control terminal, and the source of the N-channel MOS transistor is connected to the same input terminal, the drain is connected to the same output terminal, but the gate is connected to an opposite phase control terminal.

Operation of a transfer gate thus comprised is described below. It should be noted that in the following description a signal level substantially equal to the potential of the high side power supply is referred to as a "high" signal level, and a signal level substantially equal to the potential of the low side power supply is referred to as a "low" signal level. In addition, a signal of which the phase is opposite that applied to the control terminal is continually applied to the opposite phase control terminal. Only the signal applied to the control terminal is therefore considered below, and is referred to as a control signal.

When the control signal is low, both the P-channel MOS transistor and N-channel MOS transistor are on, the transfer gate is open, and the signal applied to the input terminal passes to the output terminal. When the control signal is high, both the P-channel MOS transistor and N-channel MOS transistor are off, the transfer gate is closed, and the output terminal is isolated from the input terminal.

An inverter, which is another element of this dynamic circuit, also comprises a p-channel MOS transistor and n-channel MOS transistor where the source of the P-channel MOS transistor is connected to a high side power supply terminal, the drain is connected to an output terminal, and the gate to an input terminal, and the source of the N-channel MOS transistor is connected to a low side power supply terminal, the drain is connected to the same output terminal, and the gate to the same input terminal.

Operation of an inverter thus comprised is described below. When a high signal is input to the input terminal, the P-channel MOS transistor is off and the N-channel MOS transistor is on, and a low level signal, that is, a signal level opposite the input signal level, is output from the output terminal. When a low level signal is applied to the input terminal, the P-channel MOS transistor is on and the N-channel MOS transistor is off, and a high level signal, that is, a signal level opposite the input signal level, is output from the output terminal.

A conventional dynamic latch circuit is described next.

A typical dynamic latch circuit comprises a transfer gate and an inverter. The input terminal of the transfer gate is connected to a data input terminal, the output terminal is connected to a node, the control terminal is connected to a clock terminal, and an opposite phase control terminal is connected to an opposite phase clock terminal. The input terminal of the inverter is connected to the above-noted node, and the output terminal is connected to a data output terminal.

The operation of a dynamic latch circuit thus comprised is described next.

It should be noted that a signal of which the phase is opposite that applied to the clock terminal is continually applied to the opposite phase clock terminal. Only the signal applied to the clock terminal is therefore considered below, and is referred to as the clock signal.

When the clock signal is low, the transfer gate is open, the output value from the data input terminal is written to the node, and the inverse of the written value is output from the data output terminal by the inverter. When the clock signal goes high, the transfer gate closes, the node becomes a dynamic node, the value written when the clock signal was low is held irrespective of the signal level applied to the data input terminal, and the inverse of that value is output from the data output terminal by the inverter.

When the clock signal stops high, the charge held by the dynamic node is gradually lost over time through the closed transfer gate due to the subthreshold current of the MOS transistor, and the charge held by the dynamic node is thus ultimately lost.

To solve this problem, the following two static latch circuits have been previously proposed. Note that the first of these conventional static latch circuit described below is hereinafter referred to as the first static latch circuit of the prior art, and the other is likewise referred to as the second static latch circuit of the prior art.

This first static latch circuit of the prior art is a latch circuit comprising: a transfer gate of which the input terminal is connected to a data input terminal, the output terminal is connected to a node, the control terminal is connected to a clock terminal, and an opposite phase control terminal is connected to an opposite phase clock terminal; a first inverter of which the input terminal is connected to said node, and the output terminal is connected to a data output terminal; and a second inverter of which the input terminal is connected to the data output terminal, and the output terminal is connected to the node.

The operation of this first static latch circuit is described below. It should be noted that a signal of which the phase is opposite that applied to the clock terminal is continually applied to the opposite phase clock terminal. Only the signal applied to the clock terminal is therefore considered below, and is referred to as the clock signal.

When the clock signal is low, the transfer gate is open, the output value from the data input terminal is written to the node, and the inverse of the written value is output from the data output terminal by the first inverter. When the clock signal goes high, the transfer gate closes, but the value stored to the node is statically held by the latch circuit formed by the first and second inverters. As a result, the value is not lost when clock signal supply stops, the value written when the clock signal was low is held irrespective of the signal level applied to the data input terminal, and the inverse of that value is output from the data output terminal by the first inverter.

When the clock signal changes from high to low in this case, the write operation through the transfer gate and the holding operation of the second inverter conflict, resulting in such problems as writing being disabled, writing operations being delayed, and power consumption increasing. To prevent these problems, it is therefore necessary to reduce the drive capacity of the second inverter by, for example, decreasing the gate width or increasing the gate length of the transistors.

With this first static latch circuit according to the prior art the charge stored to the node is held by the latch circuit formed by the first and second inverters even when the clock signal stops at a high level, but it is necessary to relatively weaken the drive capacity of the second inverter. To do this, the gate width of transistors in other circuit components (that is, the transfer gate, first inverter, and other gate circuits) must be large relative to the gate width of the transistor in the second inverter.

A problem with this first static latch circuit according to the prior art, therefore, it that the latch circuit cannot be achieved using transistors having the smallest usable gate width, and power consumption therefore increases. Furthermore, to minimize the increase in the gate width of other circuit components, the gate length of the transistor in the second inverter must be increased. This leads to a further problem, specifically a loss of operating speed due to an increase in the first inverter load, or the inability to use this first static latch circuit in applications where only transistors having the same gate length can be used, such as in a gate array.

The second static latch circuit according to the prior art is taught in JP-A-8-256044 and is described below. This second static latch circuit is achieved by adding a second inverter to a latch circuit comprising a first inverter. More specifically, this latch circuit comprises a transfer gate of which the input terminal is connected to a data input terminal, an output terminal is connected to a first node, a control terminal is connected to a clock terminal, and an opposite phase control terminal is connected to an opposite phase clock terminal; and a first inverter of which the input terminal is connected to the first node, and the output terminal is connected to a data output terminal. The second inverter added to this latch circuit comprises a first p-channel MOS transistor of which the source is connected to a high side power supply terminal, the drain is connected to a second node, and the gate is connected to a low side power supply terminal; a second p-channel MOS transistor of which the source is connected to the second node, the drain is connected to the first node, and the gate is connected to the data output terminal; a first n-channel MOS transistor of which the source is connected to the low side power supply terminal, the drain is connected to a third node, and the gate is connected to the high side power supply terminal; and a second n-channel MOS transistor of which the source is connected to the third node, the drain is connected to the first node, and the gate is connected to the data output terminal.

Operation of this second static latch circuit according to the prior art is described next below. It should be noted that a signal of which the phase is opposite that applied to the clock terminal is continually applied to the opposite phase clock terminal. Only the signal applied to the clock terminal is therefore considered below, and is referred to as the clock signal.

Operation of the second inverter is described first. The gate of the first P-channel MOS transistor is connected to the low side power supply terminal and is normally on because a low level signal is applied. The gate of the first N-channel MOS transistor is connected to the high side power supply terminal from which a high level signal is applied, and is therefore normally off. The logic operation of the second inverter is determined by the states of the second P-channel MOS transistor and the second N-channel MOS transistor.

When the data output terminal is high, the second P-channel MOS transistor is off, the second N-channel MOS transistor is on, and the first node therefore goes low. When the data output terminal is low, the second P-channel MOS transistor is on, the second N-channel MOS transistor is off, and first node goes high. The logic operation of the second inverter is the same as the normal inverter described above.

By using the method described below to reduce the drive capacity of the second inverter, however, interference between the holding operation of the second inverter and the write operation through the transfer gate can be reduced. That is, the gate width of the first and second P-channel MOS transistors, and the first and second N-channel MOS transistors, is made smaller than the gate width of the MOS transistors used in the other circuit components, including, for example, the transfer gates, first inverter, and other circuit blocks. The gate length of the first P-channel MOS transistor and the first N-channel MOS transistor is also made greater than the gate length of the MOS transistors used in the other circuit components. While the second P-channel MOS transistor and second N-channel MOS transistor determine the first inverter load, unlike the first static latch circuit of the prior art described above, this second static latch circuit can use a second P-channel MOS transistor and second N-channel MOS transistor with the shortest gate length. As a result, the drive capacity of the second inverter can be decreased without increasing the first inverter load. This second static latch circuit of the prior art can therefore operate at a faster speed than the above-noted first static latch circuit.

The overall operation of this second static latch circuit according to the prior art is described next. Operation itself is the same as that of the first static latch circuit. That is, when the clock signal is low, the transfer gate is open, the value supplied from the data input terminal is written to the first node, and the inverse of the written value is output from the data output terminal by the first inverter. When the clock signal goes high, the transfer gate closes, but the value stored to the first node is statically held by the latch circuit formed by the first and second inverters. As a result, the value is not lost when clock signal supply stops, the value written when the clock signal was low is held irrespective of the signal level applied to the data input terminal, and the inverse of that value is output to the data output terminal by the first inverter.

It should be noted that of the transistors used for the second inverter in the above-described second static latch circuit of the prior art, transistors with a normal gate length are used for the second P-channel MOS transistor and second N-channel MOS transistor connected to the output of the first inverter, and transistors with a long gate length are used for the first P-channel MOS transistor and first N-channel MOS transistor. By thus controlling the gate length, the above-described second static latch circuit of the prior art can simultaneously suppress speed degradation while reducing drive capacity. This second static latch circuit, however, still requires the gate width of transistors used in other circuit components (such as the transfer gate, first inverter, and other gate circuits) to be relatively greater than the gate width of the transistors in the second inverter. The latch circuit therefore cannot be achieved using transistors with the smallest usable gate width, and power consumption rises. Furthermore, the gate length of the second P-channel MOS transistor and the second N-channel MOS transistor must also be increased, and this second static latch circuit therefore cannot be used in applications where only transistors having the same gate length, such as a gate array, can be used.

A conventional dynamic logic circuit is described next.

A conventional dynamic logic circuit comprises a p-channel MOS transistor, a logic operator having first, second, and third n-channel MOS transistors, and a fourth n-channel MOS transistor. More specifically, the source of the P-channel MOS transistor is connected to a high side power supply terminal, the drain is connected to a data output terminal and the gate is connected to a clock terminal. In the logic operator, the source of the first N-channel MOS transistor is connected to a first node, the drain is connected to the data output terminal, and the gate is connected to a second data input terminal; the source of the second N-channel MOS transistor is connected to the first node, the drain to the data output terminal, and the gate to a third data input terminal ; and the source of the third N-channel MOS transistor is connected to a second node, the drain to the first node, and the gate to a first data input terminal. The source of the fourth N-channel MOS transistor is connected to a low side power supply terminal,the drain to the second node, and the gate to the clock terminal.

Operation of a conventional dynamic logic circuit thus comprised is described next below . It should be noted that the signal applied to the clock terminal is referred to as the clock signal below.

When the clock signal is low, the P-channel MOS transistor is on, the fourth N-channel MOS transistor is off, and the data output terminal is charged to a high level. When the clock signal goes high, the P-channel MOS transistor goes off, and the fourth N-channel MOS transistor goes on. If at least one of the first and second N-channel MOS transistors is on at this time and the third N-channel MOS transistor is on, the data output terminal is discharged to a low level, but otherwise the data output terminal is held high. As a result, the data output terminal state is dynamically held high. This dynamic charge is gradually discharged through the first to third N-channel MOS transistors of the logic circuit and the fourth N-channel MOS transistor. However, if the clock signal is constantly applied, the dynamic charge is recharged when the clock signal is low and a high level is held, but the charge is lost when clock signal supply stops.

The following two static logic circuits are known from the literature as a means of solving the above problem. One of these two static logic circuits is described by way of example below, and is referred to as the first static logic circuit of the prior art. This first static logic circuit of the prior art is achieved by adding a second P-channel MOS transistor to a logic circuit having a first P-channel MOS transistor.

The source of this first P-channel MOS transistor is connected to a high side power supply terminal, the drain to a data output terminal, and the gate to a clock terminal. The logic circuit comprises a logic operator having first, second, and third n-channel MOS transistors, and a fourth n-channel MOS transistor. More specifically, the source of the first N-channel MOS transistor in the logic operator is connected to a first node, the drain is connected to the data output terminal, and the gate is connected to a second data input terminal; the source of the second N-channel MOS transistor is connected to the first node, the drain to the data output terminal, and the gate to a third data input terminal; and the source of the third N-channel MOS transistor is connected to a second node, the drain to the first node, and the gate to a first data input terminal. The source of the fourth N-channel MOS transistor is connected to a low side power supply terminal, the drain to the second node, and the gate to the clock terminal. The source of the second P-channel MOS transistor is connected to the high side power supply terminal, the drain to the data output terminal, and the gate to the low side power supply terminal.

Operation of this conventional first static logic circuit is described next below. It should be noted that the signal applied to the clock terminal is referred to as the clock signal below. When the clock signal is low, the first P-channel MOS transistor is on, the fourth N-channel MOS transistor is off, and the data output terminal is charged to a high level. When the clock signal goes high, the first P-channel MOS transistor goes off, and the fourth N-channel MOS transistor goes on. If at least one of the first and second N-channel MOS transistors is on at this time and the third N-channel MOS transistor is on, the data output terminal is discharged to a low level. Because the gate of the second P-channel MOS transistor is connected to the low aide power supply terminal and is constantly on, a dc current path is formed in sequence from the high side power supply terminal, the second P-channel MOS transistor, the first to third N-channel MOS transistors in the logic circuit, the fourth N-channel MOS transistor, and the low side power supply terminal.

If the gate width of the first P-channel MOS transistor is decreased, current is reduced, and the on resistance is increased, the potential rises slightly from the low side power supply potential, but the data output terminal outputs low. Under other conditions, however, the data output terminal state is not held dynamically even when the clock signal supply stops because the second P-channel MOS transistor is always on, and the data output terminal can be held high. It is therefore possible with this first static logic circuit to hold a high state even when the clock signal is interrupted because a slight increase in the standby current is allowed when outputting low.

With the above-noted first static logic circuit of the prior art, the data output terminal does not vary dynamically and can be held high even when the clock signal stops at a high level because the second P-channel MOS transistor is always on. However, if the on resistance is not increased by adjusting the gate width and gate length of the second P-channel MOS transistor, a sufficiently low level cannot be output. Therefore, as in the case of the above-noted latch circuit, the gate width of the second P-channel MOS transistor must be less than the gate width of the other transistors in the logic circuit and the transistors used in other gate elements, and the gate length must be greater. As a result, the logic circuit cannot be constructed using transistors with the smallest usable gate width, and power consumption again increases.

A second static logic circuit according to the prior art is described next below. This second static logic circuit is achieved by adding a holding circuit to a dynamic circuit, that is, by adding a second P-channel MOS transistor and an inverter to a logic circuit comprising a first P-channel MOS transistor.

This logic circuit comprises a first P-channel MOS transistor, a logic operator having first, second, and third n-channel MOS transistors, and a fourth n-channel MOS transistor.

The source of this first P-channel MOS transistor is connected to a high side power supply terminal, the drain to a third node, and the gate to a clock terminal. The source of the first N-channel MOS transistor in the logic operator is connected to a first node, the drain is connected to the third node, and the gate is connected to a second data input terminal; the source of the second N-channel MOS transistor is connected to the first node, the drain to the third node, and the gate to a third data input terminal; and the source of the third N-channel MOS transistor is connected to a second node, the drain to the first node, and the gate to a first data input terminal. The source of the fourth N-channel MOS transistor is connected to a low side power supply terminal, the drain to the second node, and the gate to the clock terminal.

The source of the second P-channel MOS transistor is connected to the high side power supply terminal, the drain to the third node, and the gate to the data output terminal.

The input terminal of the inverter is connected to the third node, and the output terminal to the data output terminal.

Operation of this conventional second static logic circuit is described next below. It should be noted that the signal applied to the clock terminal is referred to as the clock signal below. When the clock signal is low, the first P-channel MOS transistor is on, the fourth N-channel MOS transistor is off, the third node is charged high, and the data output terminal thus outputs low because of the inverter. When the clock signal goes high, the first P-channel MOS transistor goes off, and the fourth N-channel MOS transistor goes on. If at least one of the first and second N-channel MOS transistors is on at this time and the third N-channel MOS transistor is on, the third node is discharged to a low level, and the data output terminal therefore goes high. In any other case, the third node is held high, the data output terminal continues to output low, the second P-channel MOS transistor goes on, the third node is not a dynamic node, and a high static level can be held.

When the clock signal goes high from low and the charge stored to the third node is discharged in this second static logic circuit according to the prior art, problems such as discharging being disabled, the discharge time being delayed, and an increase in power consumption can occur as a result of interference between the holding operation of the inverter and the second P-channel MOS transistor, and the discharge operation of the fourth N-channel MOS transistor and the first to third N-channel MOS transistors of the logic operator. To prevent such problems, it is therefore necessary to reduce the gate width or increase the gate length of the second P-channel MOS transistor in order to reduce the drive capacity of the second P-channel MOS transistor.

With the above-noted second static logic circuit according to the prior art, a high level is held by the inverter and second P-channel MOS transistor even when the clock signal stops high. As with the first static logic circuit according to the prior art described above, however, it is necessary to reduce the gate width or increase the gate length of the second P-channel MOS transistor relative to the other transistors in the logic circuit and various gate elements.

As a result, the logic circuit cannot be constructed using transistors with the smallest usable gate width, and power consumption again increases.

In addition, a complicated optimization procedure is required to determine the ratio between the gate widths of the holding circuit and other components.

### SUMMARY OF THE INVENTION

An object of the present invention is therefore to provide a static latch circuit and a static logic circuit that can be easily achieved without optimizing gate widths and gate lengths, can be constructed using transistors of the smallest usable gate width, and thus can reduce power consumption, and can be used in applications where all gate lengths must be the same.

To achieve the above object, a static latch circuit according to the present invention comprises a circuit control terminal, data input terminal, data output terminal, first power supply terminal, second power supply terminal, a switching means disposed between the data input terminal and a first node, a latch circuit having a first inverter comprising a first first-conductive-type MOS transistor and a first second-conductive-type MOS transistor, and a second inverter comprising a second first-conductive type MOS transistor and a second second-conductive type MOS transistor.

It should be noted that in this preferred static latch circuit according to the present invention the switching means is controlled to an open or closed state by the control terminal, and is disposed between the data input terminal and a first node. In addition, the source of the first-conductive-type MOS transistor is connected to the first power supply terminal, the drain to the data output terminal, and the gate to the first node. In addition, the source of the first second-conductive-type MOS transistor is connected to the second power supply terminal, the drain to the data output terminal, and the gate to the first node. In addition, the source of the second first-conductive-type MOS transistor is connected through the second node and a first voltage conversion circuit to the first power supply terminal, the drain is connected to the first node, and the gate to the data output terminal. In addition, the source of the second second-conductive-type MOS transistor is connected through the third node and a second voltage conversion circuit to the second power supply terminal, the drain is connected to the first node, and the gate to the data output terminal.

The present invention further relates to a static logic circuit comprising a control terminal, a data input terminal group, a data output terminal, a first power supply terminal, a second power supply terminal, a first first-conductive-type MOS transistor, a first second-conductive-type MOS transistor, and a plurality of second-conductive-type MOS transistors in a serial parallel connected network with the data input terminal group connected to the gate of each second-conductive-type MOS transistor.

In this preferred static logic circuit according to the present invention, the source of the first first-conductive-type MOS transistor is connected to the first power supply terminal, the drain is connected to the data output terminal, and the gate to the control terminal. In addition, the source of the first second-conductive-type MOS transistor is connected to the second power supply terminal, the drain is connected to a first node, and the gate to the control terminal. In addition, a logic network is disposed between the data output terminal and first node. This logic network comprises a plurality of second-conductive-type MOS transistors in a serial parallel connected configuration with the data input terminal group connected to the gate of each second-conductive-type MOS transistor. In addition, a second first-conductive-type MOS transistor is added to a logic circuit comprising this logic network. In the second first-conductive-type MOS transistor, the source is connected through a second node and voltage conversion circuit to the first power supply terminal, the drain is connected to the data output terminal, and the gate is connected to the second power supply terminal.

### BRIEF DESCRIPTION OF THE DRAWINGS

These and other objects and features of the present invention will be readily understood from the following detailed description taken in conjunction with preferred embodiments thereof with reference to the accompanying drawings, in which like parts are designated by like reference numerals and in which:
Fig. 1 is a circuit diagram of a transfer gate;
Fig. 2 is a circuit diagram of an inverter;
Fig. 3 is a circuit diagram of a dynamic latch circuit according to the related art;
Fig. 4 is a circuit diagram of a first example of a static latch circuit according to the related art;
Fig. 5 is a circuit diagram of another example of a static latch circuit according to the related art;
Fig. 6 is a circuit diagram of a dynamic logic circuit according to the related art;
Fig. 7 is a circuit diagram of a first conventional static logic circuit wherein a holding circuit added to a dynamic circuit;
Fig. 8 is a circuit diagram of a second conventional static logic circuit wherein a holding circuit added to a dynamic circuit;
Fig. 9 is a circuit diagram of a static latch circuit according to a first embodiment of the present invention;
Fig. 10 is a circuit diagram of a static latch circuit according to a second embodiment of the present invention;
Fig. 11 is a circuit diagram of a static latch circuit according to a third embodiment of the present invention;
Fig. 12 is a circuit diagram of a static latch circuit according to a fourth embodiment of the present invention;
Fig. 13 is a circuit diagram of a static latch circuit according to a fifth embodiment of the present invention;
Fig. 14 is a circuit diagram of a static latch circuit according to a sixth embodiment of the present invention;
Fig. 15 is a circuit diagram of a static latch circuit according to a seventh embodiment of the present invention;
Fig. 16 is a circuit diagram of a static latch circuit according to a eighth embodiment of the present invention;
Fig. 17 is a circuit diagram of a static logic circuit according to a ninth embodiment of the present invention;
Fig. 18 is a circuit diagram of a static logic circuit according to a tenth embodiment of the present invention;
Fig. 19 is a circuit diagram of a static logic circuit according to a eleventh embodiment of the present invention;
Fig. 20 is a circuit diagram of a static logic circuit according to a twelfth embodiment of the present invention;
Fig. 21 is a circuit diagram of a static logic circuit according to a thirteenth embodiment of the present invention;
Fig. 22 is a circuit diagram of a static logic circuit according to a fourteenth embodiment of the present invention;
Fig. 23 is a circuit diagram of a static logic circuit according to a fifteenth embodiment of the present invention;
Fig. 24 is a circuit diagram of a static logic circuit according to a sixteenth embodiment of the present invention;
Fig. 25 is a circuit diagram of a static logic circuit according to a seventeenth embodiment of the present invention;
Fig. 26 is a circuit diagram of a static logic circuit according to a eighteenth embodiment of the present invention;
Fig. 27 is a circuit diagram of a static logic circuit according to a nineteenth embodiment of the present invention;

### DESCRIPTION OF THE PREFERRED EMBODIMENTS

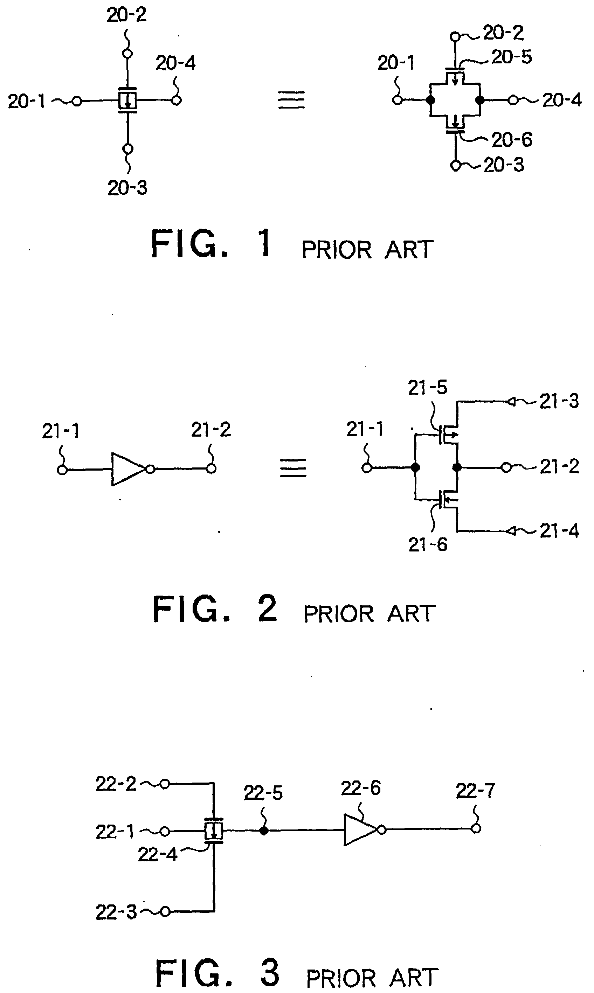

Dynamic circuits not comprising a static holding circuit are used in high speed circuits manufactured with CMOS technologies. Fig. 1 and Fig. 2 show a transfer gate and inverter used in a conventional dynamic logic circuit of this type. It should be noted that the same devices are shown on the right and left sides in Fig. 1 and Fig. 2 with the figure on the right being more detailed. A conventional dynamic latch circuit is shown in Fig. 3. A conventional dynamic latch circuit is described below.

As shown in Fig. 1, a transfer gate in such a dynamic latch circuit typically comprises a p-channel MOS transistor 20-5 and an n-channel MOS transistor 20-6. The source of the P-channel MOS transistor 20-5 is connected to an input terminal 20-1, the drain is connected to an output terminal 20-4, and the gate is connected to a control terminal 20-2. The source of the N-channel MOS transistor 20-6 is connected to the same input terminal 20-1, the drain is connected to the same output terminal 20-4, the gate is connected to an opposite phase control terminal 20-3.

Operation of a transfer gate thus comprised is described below. It should be noted that in the following description a signal level substantially equal to the potential of the high side power supply is referred to as a "high" signal level, and a signal level substantially equal to the potential of the low side power supply is referred to as a "low" signal level. In addition, a signal of which the phase is opposite that applied to the control terminal 20-2 is continually applied to the opposite phase control terminal 20-3. Only the signal applied to the control terminal 20-2 is therefore considered below, and is referred to as a control signal.

When the control signal is low, both the P-channel MOS transistor 20-5 and N-channel MOS transistor 20-6 are on, and the transfer gate opens. A signal then applied to the input terminal 20-1 passes to the output terminal 20-4. When the control signal is high, both the P-channel MOS transistor 20-5 and N-channel MOS transistor 20-6 are off and the transfer gate is closed. As a result, the output terminal 20-4 is isolated from the input terminal 20-1.

As shown in Fig. 2, an inverter in this dynamic latch circuit typically comprises a p-channel MOS transistor 21-5 and n-channel MOS transistor 21-6. The source of the P-channel MOS transistor 21-5 is connected to a high side power supply terminal 21-3, the drain is connected to an output terminal 21-2, and the gate to an input terminal 21-1. The source of the N-channel MOS transistor 21-6 is connected to a low side power supply terminal 21-4, the drain is connected to the same output terminal 21-2, and the gate to the same input terminal 21-1.

Operation of this inverter is described below. When a high signal is input to the input terminal 21-1, the P-channel MOS transistor 21-5 is off and the N-channel MOS transistor 21-6 is on. As a result, a low level signal, that is, a signal level opposite the input signal level, is output from the output terminal 21-2. When a low level signal is applied to the input terminal 21-1, the P-channel MOS transistor 21-5 is on and the N-channel MOS transistor 21-6 is off. As a result, a high level signal, that is, a signal level opposite the input signal level, is output from the output terminal 21-2.

A conventional dynamic latch circuit as shown in Fig. 3 comprises a transfer gate 22-4 and an inverter 22-6. The input terminal of the transfer gate 22-4 is connected to a data input terminal 22-1, the output terminal is connected to a node 22-5, the control terminal is connected to a clock terminal 22-2, and an opposite phase control terminal is connected to an opposite phase clock terminal 22-3. The input terminal of the inverter 22-6 is connected to the above-noted node 22-5, and the output terminal is connected to a data output terminal 22-7.

The operation of a dynamic latch circuit thus comprised as shown in Fig. 3 is described next. It should be noted that a signal of which the phase is opposite that applied to the clock terminal 22-2 is continually applied to the opposite phase clock terminal 22-3. Only the signal applied to the clock terminal 22-2 is therefore considered below, and is referred to as the clock signal.

When the clock signal is low, the transfer gate 22-4 is open, and the output value from the data input terminal 22-1 is written to the node 22-5. The inverse of the written value is output from the data output terminal 22-7 by the inverter 22-6. When the clock signal goes high, the transfer gate 22-4 closes, and the node 22-5 becomes a dynamic node. The value written when the clock signal was low is held irrespective of the signal level applied to the data input terminal 22-1, and the inverse of that value is output from the data output terminal 22-7 by the inverter 22-6.

When the clock signal supply stops at a high level, the charge held by the dynamic node 22-5 is gradually lost over time through the closed transfer gate 22-4 due to the subthreshold current of the MOS transistor, and the charge held by the dynamic node 22-5 is thus ultimately lost.

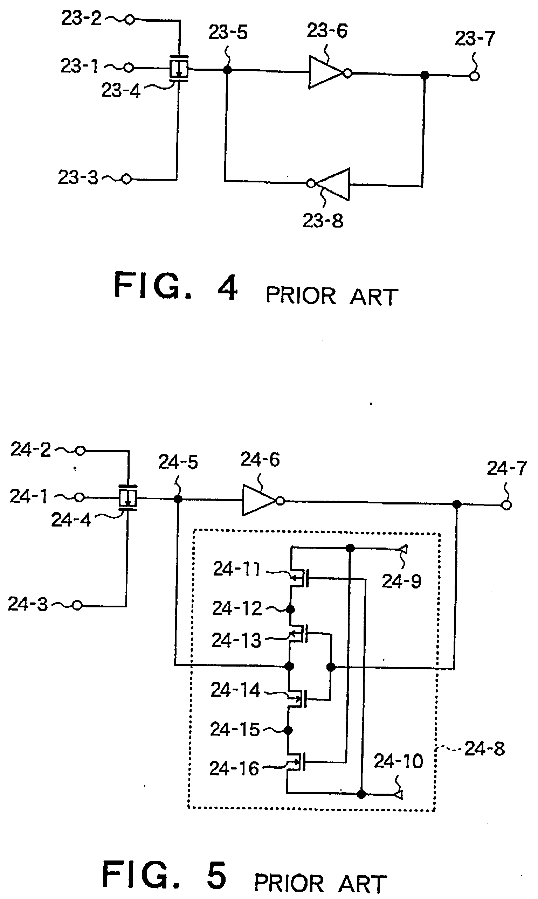

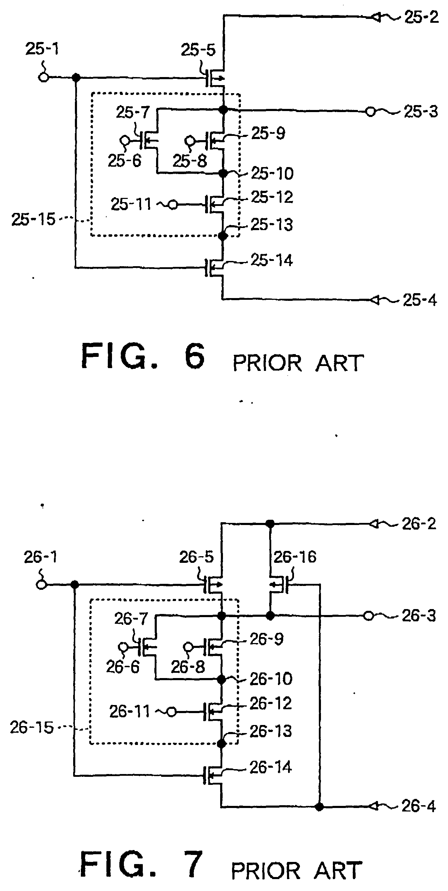

The static latch circuits Shown in Fig. 7 and Fig. 5 solve problem and are known from the literature.

The static latch circuit of the prior art shown in Fig. 4 is essentially a transfer gate 23-4 and an inverter 23-6 in a latch circuit configuration to which another inverter 23-8 is added. The input terminal of the transfer gate 23-4 is connected to a data input terminal 23-1, the output terminal is connected to a node 23-5, the control terminal is connected to a clock terminal 23-2, and an opposite phase control terminal is connected to an opposite phase clock terminal 23-3. The input terminal of the first inverter 23-6 is connected to said node 23-5, and the output terminal is connected to a data output terminal 23-7. The input terminal of the other inverter 23-8 is connected to the data output terminal 23-7, and the output terminal is connected to the node 23-5.

The operation of this first static latch circuit shown in Fig. 4 is described below. It should be noted that a signal of which the phase is opposite that applied to the clock terminal 23-2 is continually applied to the opposite phase clock terminal 23-3. Only the signal applied to the clock terminal 23-2 is therefore considered below, and is referred to as the clock signal.

When the clock signal is low, the transfer gate 23-4 opens and the value applied to the data input terminal 23-1 is written to the node 23-5. As a result, the inverse of this written value is output from the data output terminal 23-7 by the first inverter 23-6. When the clock signal goes high, the transfer gate 23-4 closes, and the value stored to the node 23-5 is statically held by the latch circuit formed by the inverters 23-6 and 23-8. As a result, the value is not lost when clock signal supply stops, and the value written when the clock signal was low is held irrespective of the signal level applied to the data input terminal 23-1. The inverse of the hold value is therefore output from the data output terminal 23-7 by the first inverter 23-6.

When the clock signal changes from high to low, the write operation through the transfer gate 23-4 and the holding operation of the second inverter 23-8 conflict, and such problems as writing being disabled, writing operations being delayed, and power consumption increasing result. To prevent these problems, it is therefore necessary to reduce the drive capacity of the second inverter 23-8 by, for example, decreasing the gate width or increasing the gate length of the transistors.

The static latch circuit shown in Fig. 5 according to the prior art is taught in JP-A-8-256044 and is described below. This static latch circuit is achieved by adding a second inverter 24-8 comprising two P-channel MOS transistors 24-11 and 24-13, and two N-channel MOS transistors 24-14 and 24-16 to a latch circuit comprising a transfer gate 24-4 and a first inverter 24-6.

More specifically, the input terminal of the transfer gate 24-4 is connected to a data input terminal 24-1, an output terminal is connected to a first node 24-5, a control terminal is connected to a clock terminal 24-2, and an opposite phase control terminal is connected to an opposite phase clock terminal 24-3. The input terminal of the first inverter 24-6 is connected to the first node 24-5, and the output terminal is connected to a data output terminal 24-7.

The source of the first p-channel MOS transistor 24-11 of the second inverter added to this latch circuit is connected to a high side power supply terminal 24-9, the drain is connected to a second node 24-12, and the gate is connected to a low side power supply terminal 24-10. The source of the second p-channel MOS transistor 24-13 is connected to the second node 24-12, the drain is connected to the first node 24-5, and the gate is connected to the data output terminal 24-7. The source of the first n-channel MOS transistor is connected to the low side power supply terminal 24-10, the drain is connected to a third node 24-15, and the gate is connected to the high side power supply terminal 24-9. The source of the second n-channel MOS transistor 24-14 is connected to the third node 24-15, the drain is connected to the first node 24-5, and the gate is connected to the data output terminal 24-7.

Operation of the second static latch circuit shown in Fig. 5 is described next below. It should be noted that a signal of which the phase is opposite that applied to the clock terminal 24-2 is continually applied to the opposite phase clock terminal 24-3. Only the signal applied to the clock terminal 24-2 is therefore considered below, and is referred to as the clock signal.

Operation of the second inverter 24-8 is described first. The gate of the first P-channel MOS transistor 24-11 is connected to the low side power supply terminal 24-10 and is normally on because a low level signal is applied. The gate of the first N-channel MOS transistor 24-16 is connected to the high side power supply terminal 24-9 from which a high level signal is applied, and is therefore normally off. The logic operation of the second inverter 24-8 is determined by the states of the second P-channel MOS transistor 24-13 and the second N-channel MOS transistor 24-14.

When the data output terminal 24-7 is high, the second P-channel MOS transistor 24-13 is off, the second N-channel MOS transistor 24-14 is on, and the first node 24-5 therefore goes low. When the data output terminal 24-7 is low, the second P-channel MOS transistor 24-13 is on, the second N-channel MOS transistor 24-14 is off, and first node 24-5 goes high. The logic operation of the second inverter 24-8 is the same as the normal inverter shown in Fig. 2 and described above.

By using the method described below to lower the drive capacity of the second inverter 24-8, however, interference between the holding operation of the second inverter 24-8 and the write operation of the transfer gate 24-4 can be reduced. That is, the gate width of the first and second P-channel MOS transistors 24-11 and 24-13, and the first and second N-channel MOS transistors 24-14 and 24-16, is made less than the gate width of the MOS transistors used in the other circuit components, including, for example, the transfer gate, first inverter 24-6, and other circuit blocks. The gate length of the first P-channel MOS transistor 24-11 and the first N-channel MOS transistor 24-16 is also made greater than the gate length of the MOS transistors used in the other circuit components. Unlike the static circuit shown in Fig. 4, the shortest gate length can be used in transistors 24-13 and 24-14, which determine the first inverter 24-6 load. As a result, the drive capacity of the second inverter can be decreased without increasing the first inverter 24-6 load. This second static latch circuit of the prior art shown in Fig. 5 can therefore operate at a faster speed than the above-noted first static latch circuit shown in Fig. 4. The overall operation of this second static latch circuit shown in Fig. 5 is described next. Operation itself is the same as that of the first static latch circuit shown in Fig. 4. That is, when the clock signal is low, the transfer gate is open, and the value supplied from the data input terminal 24-1 is written to the first node 24-5. The inverse of the written value is output from the data output terminal 24-7 by the first inverter 24-6. When the clock signal goes high, the transfer gate closes. The value stored to the first node 24-5 is statically held by the latch circuit formed by the first and second inverters 24-6 and 24-8. As a result, the value is not lost when clock signal supply stops, the value written when the clock signal was low is held irrespective of the signal level applied to the data input terminal 24-1, and the inverse of that value is output from the data output terminal 24-7 by the inverter 24-6.

A conventional dynamic logic circuit is described next with reference to Fig. 6. Fig. 6 shows a first exemplary dynamic logic circuit according to the prior art. As shown in Fig. 6, this dynamic logic circuit comprises a p-channel MOS transistor 25-5, a logic operator 25-15 having first, second, and third n-channel MOS transistors 25-7, 25-9, and 25-12, and a fourth n-channel MOS transistor 25-14.

More specifically, the source of the P-channel MOS transistor 25-5 is connected to a high side power supply terminal 25-2, the drain is connected to a data output terminal 25-3, and the gate is connected to a clock terminal 25-1. The source of the fourth N-channel MOS transistor 25-14 is connected to a low side power supply terminal 25-4, the drain to a second node 25-13 and the gate to the clock terminal 25-1. In the logic operator, the source of the third N-channel MOS transistor 25-12 is connected to the second node, the drain to the first node, and the gate to a first data input terminal 25-11. The source of the first N-channel MOS transistor 25-7 is connected to a first node, the drain is connected to the data output terminal 25-3, and the gate is connected to a second data input terminal 25-6.

The source of the second N-channel MOS transistor 25-9 is connected to the first node, the drain to the data output terminal 25-3, and the gate to a third data input terminal 25-8.

Operation of a conventional dynamic logic circuit as shown in Fig. 6 is described next below. It should be noted that the signal applied to the clock terminal 25-1 is referred to as the clock signal below.

When the clock signal is low, the P-channel MOS transistor 25-5 is on, the fourth N-channel MOS transistor 25-14 is off, and the data output terminal 25-3 is charged to a high level. When the clock signal goes high, the P-channel MOS transistor 25-5 goes off, and the fourth N-channel MOS transistor 25-14 goes on. If at least one of the first and second N-channel MOS transistors 25-7 and 25-8 is on at this time and the third N-channel MOS transistor 25-12 is on, the data output terminal 25-3 is discharged to a low level. Otherwise, the data output terminal 25-3 is held high, and the data output terminal 25-3 state thus changes dynamically. This dynamic charge is gradually discharged through the N-channel MOS transistor group of the logic circuit 25-15 and the fourth N-channel MOS transistor 25-14. However, if the clock signal is constantly applied, the dynamic charge is recharged when the clock signal is low. In this case a high level is held, but the charge is lost when clock signal supply stops.

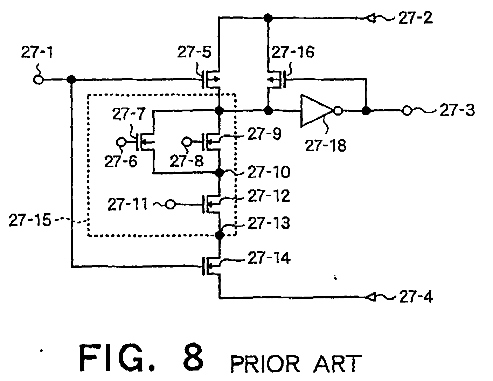

The static logic circuits shown in Fig. 7 and Fig. 8 are known from the literature as a means of solving the above problem. Note that the static logic circuit shown in Fig. 7 is an example of a static logic circuit achieved by adding a holding circuit to a dynamic circuit. More specifically, the static logic circuit shown in Fig. 7 is achieved by adding a second p-channel MOS transistor 26-16 to a logic circuit having a first p-channel MOS transistor 26-5, a fourth n-channel MOS transistor 26-14, and a logic operator 26-15 having first to third n-channel MOS transistors 26-7, 26-9, and 26-12.

The source of the first P-channel MOS transistor 26-5 is connected to a high side power supply terminal 26-2, the drain to a data output terminal 26-3, and the gate to a clock terminal 26-1. The source of the fourth N-channel MOS transistor 26-14 is connected to a low side power supply terminal 26-4, the drain to a node 26-13, and the gate to the clock terminal 26-1.

The source of the third N-channel MOS transistor 26-12 is connected to a second node 26-13, the drain to node 26-10, and the gate to a first data input terminal 26-11.

The source of the first N-channel MOS transistor 26-7 is connected to a node 26-10, the drain is connected to the data output terminal 26-3, and the gate is connected to a second data input terminal 26-6.

The source of the second N-channel MOS transistor 26-9 is connected to the first node 26-10, the drain to the data output terminal 26-3, and the gate to a third data input terminal 26-8.

The source of the second P-channel MOS transistor 26-16 is connected to the high aide power supply terminal 26-2, the drain to the data output terminal 26-3, and the gate to the low side power supply terminal 26-4.

Operation of this conventional static logic circuit shown in Fig. 7 is described next below. It should be noted that the signal applied to the clock terminal 26-1 is referred to as the clock signal below.

When the clock signal is low, the first P-channel MOS transistor 26-5 is on, the fourth N-channel MOS transistor 26-14 is off, and the data output terminal 26-3 is charged to a high level. When the clock signal goes high, the first P-channel MOS transistor 26-5 goes off, and the fourth N-channel MOS transistor 26-14 goes on. If at least one of the first and second N-channel MOS transistors 26-7 and 26-9 is on at this time and the third N-channel MOS transistor 26-12 is on, the data output terminal 26-3 is discharged to a low level. Because the gate of the second P-channel MOS transistor 26-16 is connected to the low side power supply terminal 26-4 and is constantly on, a dc current path is formed in sequence from the high side power supply terminal 26-2, the second P-channel MOS transistor 26-16, the N-channel MOS transistor group in the logic circuit 26-15, the fourth N-channel MOS transistor 26-14, and the low side power supply terminal 26-4.

If the gate width of the P-channel MOS transistor 26-5 is decreased, current is reduced, and the on resistance is increased, the potential rises slightly from the low side power supply potential. As a result, the data output terminal 26-3 outputs low. Under other conditions, however, the data output terminal 26-3 state is not held dynamically even when the clock signal supply stops because the second P-channel MOS transistor 26-16 is always on, and the data output terminal 26-3 can be held high. It is therefore possible with this static logic circuit shown in Fig. 7 to hold a high level state when the clock signal is interrupted because a slight increase in the standby current is allowed when outputting low.

A second static logic circuit in which a holding circuit is added to a dynamic circuit according to the prior art is described next below with reference to Fig. 8. More specifically, the static logic circuit shown in Fig. 8 is achieved by adding a second p-channel MOS transistor 27-16 to a logic circuit having a first p-channel MOS transistor 27-5, a fourth n-channel MOS transistor 27-14, an inverter 27-18, and a logic operator 27-15 having first to third n-channel MOS transistors 27-7, 27-9, and 27-12.

The source of this first P-channel MOS transistor 27-5 is connected to a high side power supply terminal 27-2, the drain to a node 27-17, and the gate to a clock terminal 27-1. The source of the fourth N-channel MOS transistor 27-14 is connected to a low side power supply terminal 27-4, the drain to node 27-13, and the gate to the clock terminal 27-1.

The input terminal of the inverter 27-18 is connected to node 27-17, and the output terminal to the data output terminal 27-3. The source of the third N-channel MOS transistor 27-12 is connected to a second node 27-13, the drain to the first node 27-10, and the gate to a first data input terminal 27-11. The source of the first N-channel MOS transistor 27-7 is connected to the first node 27-10, the drain is connected to the third node 27-17, and the gate is connected to a second data input terminal 27-6. The source of the second N-channel MOS transistor 27-9 is connected to the first node 27-10, the drain to the third node 27-17, and the gate to a third data input terminal 27-8.

The source of the second P-channel MOS transistor 27-16 is connected to the high side power supply terminal 27-2, the drain to the third node 27-17, and the gate to the data output terminal 27-3.

Operation of the conventional static logic circuit shown in Fig. 8 is described next below. It should be noted that the signal applied to the clock terminal 27-1 is referred to as the clock signal below. When the clock signal is low, the first P-channel MOS transistor 27-5 is on and the fourth N-channel MOS transistor 27-14 is off. The third node 27-17 is charged high, and the data output terminal 27-3 thus outputs low because of the inverter 27-18. When the clock signal goes high, the first P-channel MOS transistor 27-5 goes off, and the fourth N-channel MOS transistor 27-14 goes on. If at least one of the first and second N-channel MOS transistors 27-7 and 27-9 is on at this time and the third N-channel MOS transistor 27-12 is on, the third node 27-17 is discharged to a low level, and the data output terminal 27-3 goes high. In any other case, the third node 27-17 is held high. As a result, the data output terminal 27-3 continues to output low. In addition, because the second P-channel MOS transistor 27-16 goes on, the third node 27-17 is not dynamic, and a high static level can be held.

When the clock signal goes high from low and the charge stored to the third node 27-17 is discharged in this static logic circuit according to the prior art, the discharge operation of the N-channel MOS transistor group of the logic operator 27-15 and the fourth N-channel MOS transistor 27-14, and the holding operation of the inverter 27-18 and the second P-channel MOS transistor 2176 interfere with each other, resulting in such problems as discharging being disabled, the discharge time being delayed, and an increase in power consumption. Therefore, to prevent such problems, it is necessary to reduce the gate width or increase the gate length of the second P-channel MOS transistor 2176 in order to reduce the drive capacity of the second P-channel MOS transistor 27-16.

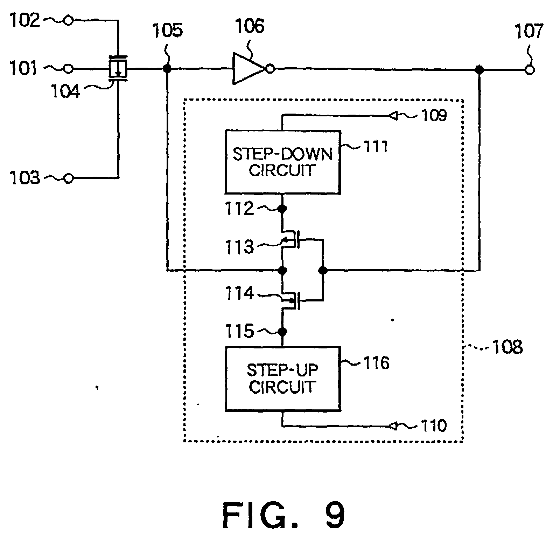

A static latch circuit according to a first embodiment of the present invention is described next with reference to Fig. 9. As shown in Fig. 9, a static latch circuit according to this first embodiment is achieved by adding an inverter 108 comprising a P-channel MOS transistor 113 and N-channel MOS transistor 114 to a latch circuit comprising a transfer gate 104 and inverter 106.

A control terminal of the transfer gate 104 is connected to a clock terminal 102, an opposite phase control terminal is connected to an opposite phase clock terminal 103, an input terminal is connected to a data input terminal 101, and an output terminal to a node 105. The input terminal of the invertor 106 is connected to the node 105, and the output terminal is connected to a data output terminal 107. The source of the P-channel MOS transistor 113 is connected through a step-down circuit 111 to a high side power supply terminal 109, the drain to the node 105, and the gate to the data output terminal 107. The source of the N-channel MOS transistor 114 is connected through a step-up circuit 116 to a low side power supply terminal 110, the drain is connected to the node 105, and the gate to the data output terminal 107. The operation of a static latch circuit according to the present invention as shown in Fig. 9 is described next. It should be noted that a signal with a phase opposite the phase of the signal applied to the clock terminal 102 is always applied to the opposite phase clock terminal 103. Only the signal applied to the clock terminal 102 is therefore considered below, and is accordingly referred to as the clock signal. In addition, latch circuit operation is the same as in a static latch circuit according to the prior art as described above. When the clock signal is low, the transfer gate 104 opens and the value applied to the data input terminal 101 is written to node 105. As a result, the inverse of this written value is output to the data output terminal 107 by the inverter 106. When the clock signal goes high, the transfer gate 104 closes, and the value stored to the node 105 is statically held by the latch circuit formed by the inverters 106 and 108. As a result, the value is not lost when clock signal supply stops. The value stored when the clock signal is low is thus held irrespective of the signal level applied to the data input terminal 101, and the inverse of the held value is output to the data output terminal 107 by the inverter 106.

To prevent problems caused by interference between the write operation of the transfer gate 104 and the holding operation of the inverter 108 when the clock signal goes low from high, the drive capacity of the inverter 108 is reduced by lowering the effective power supply voltage during operation by means of the step-down circuit 111 and step-up circuit 116.

Therefore, even if the gate width and gate length of the transistors in inverter 108 are the same as those of the transistors used in other circuit components such as the transfer gate 104, inverter 106, and other circuit blocks, the operating conditions required for a holding circuit can be met. A static latch circuit according to the present invention can therefore be achieved using transistors having the smallest possible gate width, power consumption can therefore be reduced, and a static latch circuit according to the present invention can be used in applications where all gate lengths must be the same, such as in a gate array.

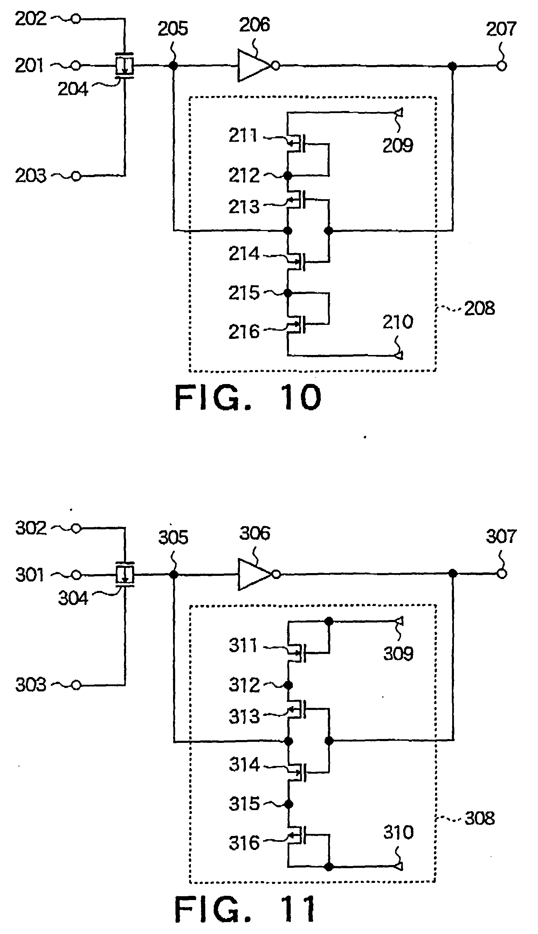

A static latch circuit according to a second embodiment of the present invention is described next with reference to Fig. 10. This second embodiment of the invention describes a first specific embodiment of the step-down circuit 111 and step-up circuit 116 in the static latch circuit according to the above first embodiment. The static latch circuit shown in Fig. 10 is achieved by adding an inverter 208 comprising P-channel MOS transistors 211 and 213 and N-channel MOS transistors 214 and 216 to a latch circuit comprising a transfer gate 204 and inverter 206.

A control terminal of the transfer gate 204 is connected to a clock terminal 202, an opposite phase control terminal is connected to an opposite phase clock terminal 203, an input terminal is connected to a data input terminal 201, and an output terminal to a node 205. The input terminal of the inverter 206 is connected to the node 205, and the output terminal is connected to a data output terminal 207. The source of P-channel MOS transistor 211 is connected to a high side power supply terminal 209, and the drain and gate are connected to a node 212. The source of P-channel MOS transistor 213 is connected to node 212, the drain to node 205, and the gate to the data output terminal 207. The source of N-channel MOS transistor 214 is connected to a node 215, the drain to node 205, and the gate to data output terminal 207. The source of the N-channel MOS transistor 216 is connected to a low side power supply terminal 210, and the drain and gate to node 215.

The operation of a static latch circuit according to the present invention as shown in Fig. 10 is described next. It should be noted that a signal with a phase opposite the phase of the signal applied to the clock terminal 202 is always applied to the opposite phase clock terminal 203. Only the signal applied to the clock terminal 202 is therefore considered below, and is accordingly referred to as the clock signal. In addition, latch circuit operation is the same as in a static latch circuit according to the prior art as described above. When the clock signal is low, the transfer gate 204 opens and the value applied to the data input terminal 201 is written to node 205. As a result, the inverse of this written value is output to the data output terminal 207 by the inverter 206. When the clock signal goes high, the transfer gate 204 closes, and the value stored to the node 205 is statically held by the latch circuit formed by the inverters 206 and 208. As a result, the value is not lost when clock signal supply stops. The value stored when the clock signal is low is thus held irrespective of the signal level applied to the data input terminal 201, and the inverse of the held value is output to the data output terminal 207 by the inverter 206.

When the clock signal goes low from high, the write operation of the transfer gate 204 and the holding operation of the inverter 208 conflict. To prevent this problem, it is therefore necessary to lower the drive capacity of the inverter 208. This is accomplished by using a diode formed by the P-channel MOS transistor 211 forward biased from high side power supply terminal 209 to node 212 as a step-down circuit, and a diode formed by the N-channel MOS transistor 216 forward biased from the node 215 to the low side power supply terminal 210 as a step-up circuit, to lower the effective power supply voltage during operation.

When an inverter such as inverter 208 is used in an application where the signal level of the node to which the inverter output terminal is connected is determined by the inverter during high speed circuit operation, operation ranges between a high signal level that is the high side potential stepped down by the on voltage of the P-channel MOS transistor 211, and a low signal level that is the low side potential stepped up by the on voltage of the N-channel MOS transistor 216, when a high speed signal is applied to the input terminal. When used in a latch circuit as shown in Fig. 10, charging and discharging the node 205 to which the output terminal is connected occurs through the transfer gate 204 by means of a gate circuit in a previous stage having a load drive capacity exceeding that of the inverter 208. As a result, a substantially full swing between high and low levels occurs while the clock signal is input.

When clock signal supply stops, the node 205 to which the inverter 208 output terminal is connected settles to either a high dc level somewhat below the high side potential, or a low dc level somewhat above the low side potential. The rise or fall from the power supply level at this time is on the level of several hundred millivolts. Because the standby current flowing to the inverter 206 is extremely low, an extremely small increase in the standby power enables a reduction in the operating power of the circuit.

Therefore, even if the gate width and gate length of the transistors in inverter 208 are the same as those of the transistors used in other circuit components such as the transfer gate 204, inverter 206, and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array.

A static latch circuit according to a third embodiment of the present invention is described next with reference to Fig. 11. A static latch circuit according to this embodiment as shown in Fig. 11 comprises a transfer gate 304, an inverter 306, and an inverter 308 having an N-channel MOS transistor 311, P-channel MOS transistor 313, N-channel MOS transistor 314, and P-channel MOS transistor 316.

A control terminal of the transfer gate 304 is connected to a clock terminal 302, an opposite phase control terminal is connected to an opposite phase clock terminal 303, an input terminal is connected to a data input terminal 301, and an output terminal to a node 305. The input terminal of the inverter 306 is connected to the node 305, and the output terminal is connected to a data output terminal 307. The drain and gate of N-channel MOS transistor 311 are connected to a high side power supply terminal 309, and the source as connected to a node 312. The source of P-channel MOS transistor 313 is connected to node 312, the drain to node 305, and the gate to the data output terminal 307. The source of N-channel MOS transistor 314 is connected to a node 315, the drain to node 305, and the gate to data output terminal 307. The drain and gate of the P-channel MOS transistor 316 are connected to a low side power supply terminal 310, and the source to node 315.

The operation of a static latch circuit according to the present invention as shown in Fig. 11 is described next.

It should be noted that a signal with a phase opposite the phase of the signal applied to the clock terminal 302 is always applied to the opposite phase clock terminal 303. Only the signal applied to the clock terminal 302 is therefore considered below, and is accordingly referred to as the clock signal. In addition, latch circuit operation is the same as in a static latch circuit according to the prior art as described above. When the clock signal is low, the transfer gate 304 opens and the value applied to the data input terminal 301 is written to node 305. As a result, the inverse of this written value is output to the data output terminal 307 by the inverter 306. When the clock signal goes high, the transfer gate 304 closes, and the value stored to the node 305 is statically held by the latch circuit formed by the inverters 306 and 308. As a result, the value is not lost when clock signal supply stops. The value stored when the clock signal is low is thus held irrespective of the signal level applied to the data input terminal 301, and the inverse of the held value is output to the data output terminal 307 by the inverter 306.

When the clock signal then goes low from high, the write operation of the transfer gate 304 and the holding operation of the inverter 308 conflict. To prevent this problem, it is therefore necessary to lower the drive capacity of the inverter 308. This is accomplished by using a diode formed by the N-channel MOS transistor 311 forward biased from high side power supply terminal 309 to node 211 as a step-down circuit, and a diode formed by the P-channel MOS transistor 316 forward biased from the node 315 to the low side power supply terminal 310 as a step-up circuit, to lower the effective power supply voltage during operation.

When an inverter such as inverter 308 is used in an application where the signal level of the node to which the invertor output terminal is connected is determined by the invertor during high speed circuit operation, operation ranges between a high signal level that is the high side potential stepped down by the on voltage of the N-channel MOS transistor 311, and a low signal level that is the low side potential stepped up by the on voltage of the P-channel MOS transistor 316, when a high speed signal is applied to the input terminal. When used in a latch circuit as shown in Fig. 11, charging and discharging the node 305 to which the output terminal is connected occurs through the transfer gate 304 by means of a gate circuit in a previous stage having a load drive capacity exceeding that of the inverter 308. As a result, a substantially full swing between high and low levels occurs while the clock signal is input.

When clock signal supply stops, the node 305 to which the inverter 308 output terminal is connected settles to either a high dc level somewhat below the high side potential, or a low dc level somewhat above the low side potential. The rise or fall from the power supply level at this time is on the level of several hundred millivolts. Because the standby current flowing to the inverter 306 is extremely low, an extremely small increase in the standby power enables a reduction in the operating power of the circuit.

Therefore, even if the gate width and gate length of the transistors in inverter 308 are the same as those of the transistors used in other circuit components such as the transfer gate 304, inverter 306, and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array.

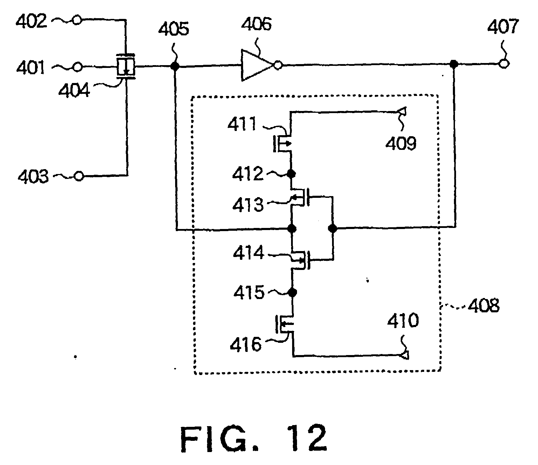

A static latch circuit according to a fourth embodiment of the present invention is described next with reference to Fig. 12. A static latch circuit according to this embodiment as shown in Fig. 12 comprises a transfer gate 404, an inverter 406, and an inverter 408 having a P-channel MOS transistor 411, P-channel MOS transistor 413, N-channel MOS transistor 414, and N-channel MOS transistor 416.

A control terminal of the transfer gate 404 is connected to a clock terminal 402, an opposite phase Control terminal is connected to an opposite phase clock terminal 403, an input terminal is connected to a data input terminal 401, and an output terminal to a node 405. The input terminal of the inverter 406 is connected to the node 405, and the output terminal is connected to a data output terminal 407. The source of P-channel MOS transistor 411 is connected to a high side power supply terminal 409, the drain is connected to a node 412, and the gate to node 405. The source of P-channel MOS transistor 413 is connected to node 412, the drain to node 405, and the gate to the data output terminal 407. The source of N-channel MOS transistor 414 is connected to a node 415, the drain to node 405, and the gate to data output terminal 407. The source of the N-channel MOS transistor 416 is connected to a low side power supply terminal 410, the drain to node 415, and the gate to node 405.

The operation of a static latch circuit according to the present invention as shown in Fig. 11 is described next.

It should be noted that a signal with a phase opposite the phase of the signal applied to the clock terminal 402 is always applied to the opposite phase clock terminal 403. Only the signal applied to the clock terminal 402 is therefore considered below, and is accordingly referred to as the clock signal.

In addition, latch circuit operation is the same as in a static latch circuit according to the prior art as described above. When the clock signal is low, the transfer gate 404 opens and the value applied to the data input terminal 401 is written to node 405. As a result, the inverse of this written value is output to the data output terminal 407 by the inverter 406. When the clock signal then goes high, the transfer gate 404 closes, and the value stored to the node 405 is statically held by the latch circuit formed by the inverters 406 and 408. As a result, the value is not lost when clock signal supply stops. The value stored when the clock signal is low is thus held irrespective of the signal level applied to the data input terminal 401, and the inverse of the held value is output to the data output terminal 407 by the inverter 406.

When the clock signal then goes low from high, the write operation of the transfer gate 404 and the holding operation of the inverter 408 conflict. To prevent this problem, it is therefore necessary to lower the drive capacity of the inverter 408. This is accomplished by using a step-down circuit and a step-up circuit to lower the effective power supply voltage during operation.

When P-channel MOS transistor 413 is on, the gate of P-channel MOS transistor 411 is electrically connected to the drain of P-channel MOS transistor 411, and as in the case of the static latch circuit shown in Fig. 10 operates as a diode type step-down circuit forward biased from the high side power supply terminal 409 to node 412.

When N-channel MOS transistor 414 is on, the gate of N-channel MOS transistor 416 is electrically connected to the drain of N-channel MOS transistor 416, and as in the case of the static latch circuit shown in Fig.2 operates as a diode type step-up circuit forward biased from node 415 to the low side power supply terminal 410.

When an inverter such as inverter 408 is used in an application where the signal level of the node to which the inverter output terminal is connected is determined by the inverter during high speed circuit operation, operation ranges between a high signal level that is the high side potential stepped down by the on voltage of the P-channel MOS transistor 411, and a low signal level that is the low side potential stepped up by the on voltage of the N-channel MOS transistor 416, when a high speed signal is applied to the input terminal. When used in a latch circuit as shown in Fig.10 charging and discharging the node 405 to which the output terminal is connected occurs through the transfer gate 404 by means of a gate circuit in a previous stage having a load drive capacity exceeding that of the inverter 408. As a result, a substantially full swing between high and low levels occurs while the clock signal is input.

When clock signal supply stops, the node 405 to which the inverter 408 output terminal is connected settles to either a high dc level somewhat below the high side potential, or a low dc level somewhat above the low side potential. The rise or fall from the power supply level at this time is on the level of several hundred millivolts. Because the standby current flowing to the inverter 406 is extremely low, an extremely small increase in the standby power enables a reduction in the operating power of the circuit.

Therefore, even if the gate width and gate length of the transistors in inverter 408 are the same as those of the transistors used in other circuit components such as the transfer gate 404, inverter 406, and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array.

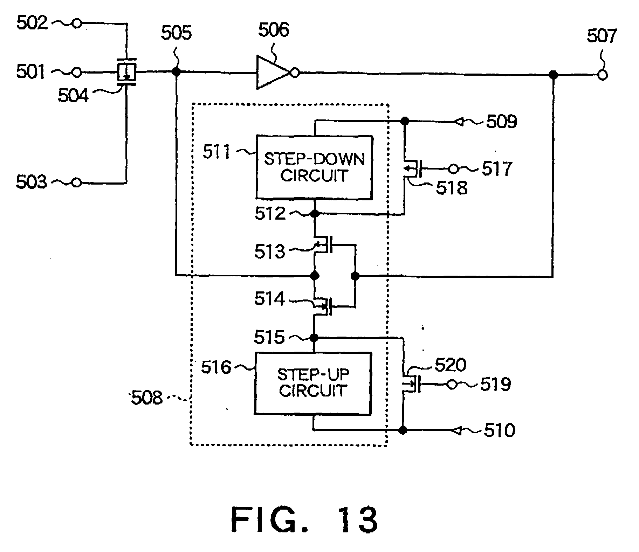

A static latch circuit according to a fifth embodiment of the present invention is described next with reference to Fig. 13. A static latch circuit according to this embodiment as shown in Fig. 13 comprises a transfer gate 504, an inverter 506, an inverter 508 having a P-channel MOS transistor 513 and N-channel MOS transistor 514, a P-channel MOS transistor 518, and an N-channel MOS transistor 520.

A control terminal of the transfer gate 504 is connected to a clock terminal 502, an opposite phase control terminal is connected to an opposite phase clock terminal 503, an input terminal is connected to a data input terminal 501, and an output terminal to a node 505. The input terminal of the inverter 506 is connected to the node 505, and the output terminal is connected to a data output terminal 507.

The source of P-channel MOS transistor 513 is connected through node 512 and step-down circuit 511 to a high side power supply terminal 509, the drain to node 505, and the gate to the data output terminal 507. The source of N-channel MOS transistor 514 is connected through a node 515 and step-up circuit 516 to a low side power supply terminal 510, the drain to node 505, and the gate to data output terminal 507. The source of P-channel MOS transistor 518 is connected to high side power supply terminal 509, the drain to node 512, and the gate to a standby control terminal 517.

The source of the N-channel MOS transistor 520 is connected to a low side power supply terminal 510, the drain to node 515, and the gate to an opposite phase standby control terminal 519.

The operation of a static latch circuit according to the present invention as shown in Fig. 13 is described next.

It should be noted that a signal with a phase opposite the phase of the signal applied to the clock terminal 502 is always applied to the opposite phase clock terminal 503. Only the signal applied to the clock terminal 502 is therefore considered below, and is accordingly referred to as the clock signal. It should also be noted that a signal with a phase opposite the phase of the signal applied to the standby control terminal 509 is always applied to the opposite phase standby control terminal 519. Only the signal applied to the standby control terminal 509 is therefore considered below, and is accordingly referred to as the standby control signal. When the standby control signal is low, both P-channel MOS transistor 518 and N-channel MOS transistor 520 are off, and these can therefore be ignored with respect to circuit operation when the standby control signal is low. Furthermore, the latch operation of the latch circuit shown in Fig. 13 is the same as that shown in Fig. 9.

When the clock signal stops, the node corresponding to node 505 in the latch circuits shown in Fig. 9 to Fig. 12 settles to a level of several hundred millivolts at a high dc level somewhat below the high side potential, or a low dc level somewhat above the low side potential, and slight standby power is consumed by the inverter corresponding to inverter 506. In this case, the P-channel MOS transistor 518 and N-channel MOS transistor 520 can be turned on by setting the standby control signal high when the clock signal stops. The node 505 thus settles to the high or low side level, and the effects achieved by the latch circuits shown in Fig. 9 to Fig. 12 can be achieved without increasing the standby power of the inverter 506.

Therefore, even if the gate width and gate length of the transistors in inverter 508 are the same as those of the transistors used in other circuit components such as the transfer gate 504, inverter 506, and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array. It should be further noted that any of the step-up circuits and step-down circuits shown in Fig. 10 to Fig. 12 can be used for the step-down circuit 511 and step-up circuit 516 shown in Fig. 13.

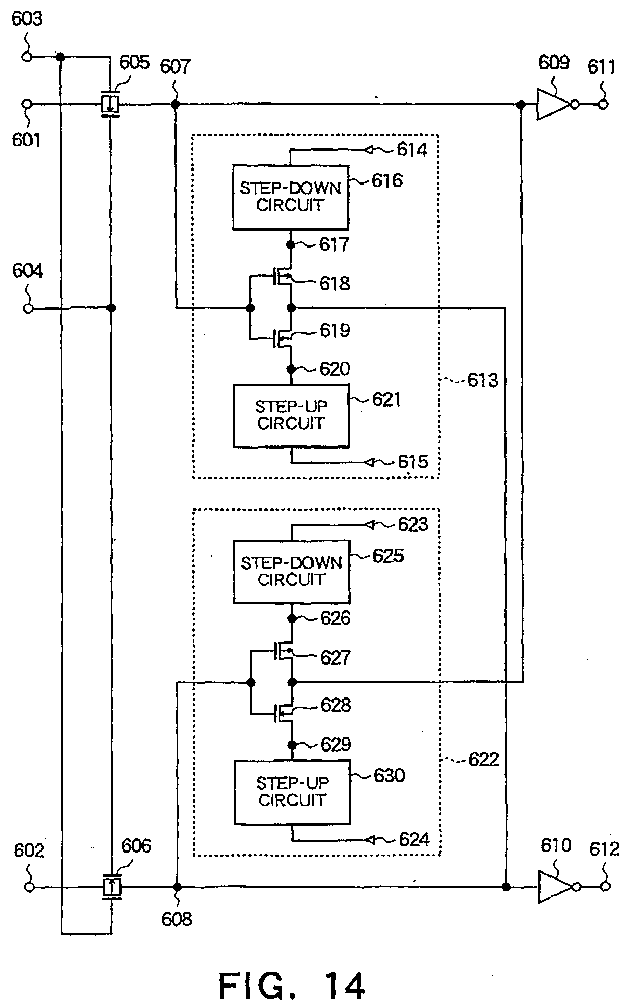

A static latch circuit according to a sixth embodiment of the present invention is described next with reference to Fig. 14. A static latch circuit according to third embodiment as shown in Fig. 14 comprises a transfer gate 605, a transfer gate 606, an inverter 609, an inverter 610, an inverter 613 having a P-channel MOS transistor 618 and an N-channel MOS transistor 619, and an inverter 622 having a P-channel MOS transistor 627 and an N-channel MOS transistor 628.

A control terminal of transfer gate 605 is connected to a clock terminal 603, an opposite phase control terminal is connected to an opposite phase clock terminal 604, an input terminal is connected to a data input terminal 601, and an output terminal to a node 607. A control terminal of transfer gate 606 is connected to clock terminal 603, an opposite phase control terminal is connected to opposite phase clock terminal 604, an input terminal is connected to an opposite phase data input terminal 602,and an output terminal to a node 608. The input terminal of inverter 609 is connected to node 607, and the output terminal is connected to a data output terminal 611. The input terminal of inverter 610 is connected to node 608, and the output terminal is connected to an opposite phase data output terminal 612.

The source of P-channel MOS transistor 618 is connected through step-down circuit 616 to a high side power supply terminal 614, the drain to node 608, and the gate to node 607. The source of N-channel MOS transistor 619 is connected through step-up circuit 621 to a low side power supply terminal 615, the drain to node 608, and the gate to node 607. The source of P-channel MOS transistor 627 is connected through step-down circuit 625 to a high side power supply terminal 623, the drain to node 607, and the gate to node 608. The source of N-channel MOS transistor 628 is connected through step-up circuit 630 to a low side power supply terminal 624, the drain to node 607, and the gate to node 608.

The operation of a static latch circuit according to the present invention as shown in Fig. 14 is described next. It should be noted that a signal with a phase opposite the phase of the signal applied to the clock terminal 603 is always applied to the opposite phase clock terminal 604. Only the signal applied to the clock terminal 603 is therefore considered below, and is accordingly referred to as the clock signal. When the clock signal is low, transfer gates 605 and 606 open and the value applied to the data input terminal 601 is written to node 607. As a result, the inverse of this written value is output to the data output terminal 611 by the inverter 609. The value applied to the opposite phase data input terminal 602 is also written to node 608, and the inverse of this written value is output to the data output terminal 612 by the inverter 610.

When the clock signal then goes high, transfer gates 605 and 606 close, and the values stored to nodes 607 and 608 are statically held by the latch circuit formed by the inverters 613 and 622. As a result, the values are not lost when the clock signal stops. The values stored when the clock signal is low are thus held irrespective of the signals applied to the data input terminal 601 and opposite phase data input terminal 602.

When the clock signal then goes low from high, the write operation of transfer gate 605 and the holding operation of inverter 622 conflict. It is therefore necessary to lower the drive capacity of inverters 613 and 622 to prevent problems resulting from conflict between the write operation of transfer gate 606 and the holding operation of inverter 613. This is accomplished by using the step-down circuits 616 and 625 and step-up circuits 621 and 630 of inverters 613 and 622, respectively, to lower the effective power supply voltage during operation.

Therefore, even if the gate width and gate length of the transistors in inverters 613 and 622 are the same as those of the transistors used in other circuit components such as the transfer gates 605 and 606, inverters 609 and 610, and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array.

It should be further noted that any of the step-up circuits and step-down circuits shown in Fig. 10 to Fig. 12 can be used for the step-up circuits 616 and 625 and step-down circuits 621 and 630 shown in Fig. 14.

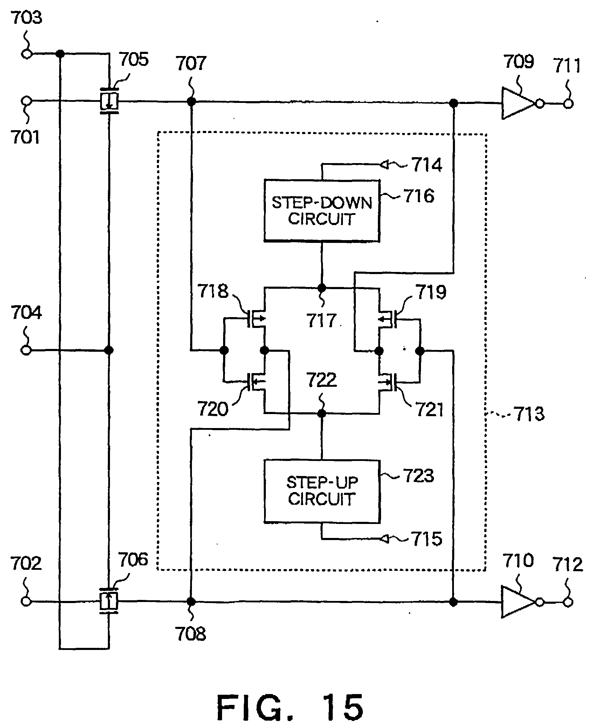

A static latch circuit according to a seventh embodiment of the present invention is described next with reference to Fig. 15. A static latch circuit according to this embodiment as shown in Fig. 15 is achieved by adding a P-channel MOS transistor 718, N-channel MOS transistor 720, P-channel MOS transistor 719, and N-channel MOS transistor 721 to a latch circuit having transfer gates 705 and 706 and an inverter 710.

A control terminal of transfer gate 705 is connected to a clock terminal 703, an opposite phase control terminal is connected to an opposite phase clock terminal 704, an input terminal is connected to a data input terminal 701, and an output terminal to a node 707. A control terminal of transfer gate 706 is connected to clock terminal 703, an opposite phase control terminal is connected to opposite phase clock terminal 704, an input terminal is connected to an opposite phase data input terminal 702, and an output terminal to a node 708. The input terminal of inverter 709 is connected to node 707, and the output terminal is connected to a data output terminal 711. The input terminal of inverter 710 is connected to node 708, and the output terminal is connected to an opposite phase data output terminal 712. The source of P-channel MOS transistor 718 is connected through node 717 and step-down circuit 716 to a high side power supply terminal 714, the drain to node 708, and the gate to node 707. The source of N-channel MOS transistor 720 is connected through node 722 and step-up circuit 723 to a low side power supply terminal 715, the drain to node 708, and the gate to node 707. The source of P-channel MOS transistor 719 is connected to node 717, the drain to node 707, and the gate to node 708. The source of N-channel MOS transistor 721 is connected to node 722, the drain to node 707, and the gate to node 708.

The operation of a static latch circuit according to the present invention as shown in Fig. 15 is described next.

It should be noted that a signal with a phase opposite the phase of the signal applied to the clock terminal 703 is always applied to the opposite phase clock terminal 704. Only the signal applied to the clock terminal 703 is therefore considered below, and is accordingly referred to as the clock signal. When the clock signal is low, transfer gates 705 and 706 open and the value applied to the data input terminal 701 is written to node 707. As a result, the inverse of this written value is output to the data output terminal 711 by the inverter 709. The value applied to the opposite phase data input terminal 702 is also written to node 708, and the inverse of this written value is output to the data output terminal 712 by the inverter 710.

When the clock signal then goes high, transfer gates 705 and 706 close. While the version of the invention shown in Fig. 14 uses separate step-down and step-up circuits, the values stored to nodes 707 and 708 are statically held by a holding circuit 713 in which a single step-down circuit 716 and a single step-up circuit 723 are shared. As a result, the values are not lost when the clock signal stops. The values stored when the clock signal is low are thus held irrespective of the signals applied to the data input terminal 701 and opposite phase data input terminal 702.

When the clock signal then goes low from high, the write operation of transfer gates 705 and 706 and the holding operation of holding circuit 713 conflict. To prevent this problem, it is necessary to lower the drive capacity of holding circuit 713. This is accomplished by using step-down circuit 716 and step-up circuit 723 to lower the effective power supply voltage during operation.

Therefore, even if the gate width and gate length of the transistors in holding circuit inverter 713 are the same as those of the transistors used in other circuit components such as the transfer gates 705 and 706, inverters 709 and 710, and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array.

It should be further noted that any of the step-up circuits and step-down circuits shown in Fig. 10 to Fig. 12 can be used for the step-up circuit 716 and step-down circuit 723 shown in Fig. 15.

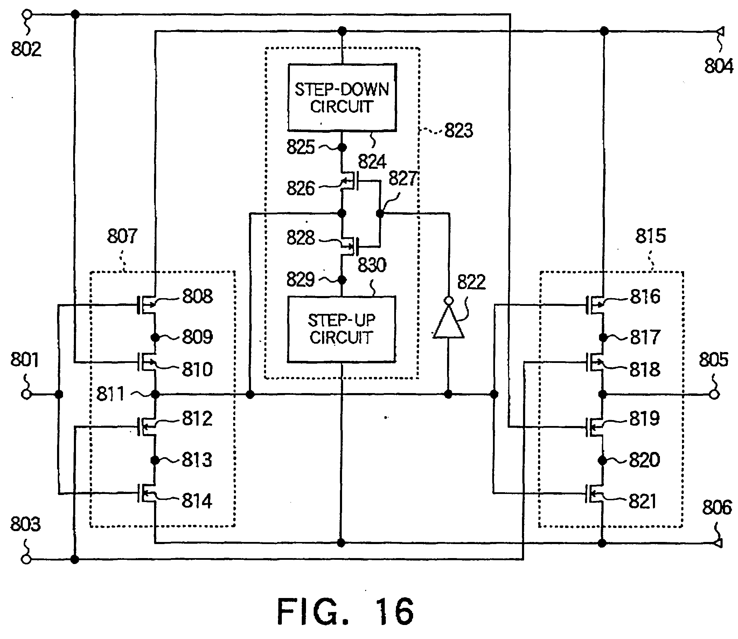

A static latch circuit according to an eighth embodiment of the present invention is described next with reference to Fig. 16. A static latch circuit according to this embodiment as shown in Fig. 16 is achieved by adding a inverter 822 and a inverter 823 comprising a P-channel MOS transistor 826 and N-channel MOS transistor 828 to a latch circuit comprising a [first] inverter 807 and a [second] inverter 815 where the [first] inverter 807 has P-channel MOS transistors 808 and 810 and N-channel MOS transistors 814 and 812, and the [second] inverter 815 has P-channel MOS transistors 817 and 818 and N-channel MOS transistors 821 and 819.

The source of P-channel MOS transistor 808 is connected to high side power supply terminal 804, the drain to node 809, and the gate to data input terminal 801. The source of P-channel MOS transistor 810 is connected to node 809, the drain to node 811, and the gate to clock terminal 802. The source of N-channel MOS transistor 814 is connected to a low side power supply terminal 806, the drain to node 813, and the gate to data input terminal 801. The source of N-channel MOS transistor 812 is connected to node 813, the drain to node 811, and the gate to opposite phase clock terminal 803. The source of P-channel MOS transistor 817 is connected to high side power supply terminal 804, the drain to node 817, and the gate to node 811. The source of P-channel MOS transistor 818 is connected to node 817, the drain to data output terminal 805, and the gate to opposite phase clock terminal 803. The source of N-channel MOS transistor 821 is connected to low side power supply terminal 806, the drain to node 820, and the gate to node 811. The source of N-channel MOS transistor 819 is connected to node 820, the drain to data output terminal 805, and the gate to clock terminal 802. The input terminal of inverter 822 is connected to node 811, and the output terminal to node 827. The source of P-channel MOS transistor 826 is connected through step-down circuit 824 to the high side power supply terminal 804, the drain to node 811, and the gate to node 827. The source of N-channel MOS transistor 828 is connected through step-up circuit 830 to the low side power supply terminal 806, the drain to node 811, and the gate to node 827.

The operation of a static latch circuit according to the present invention as shown in Fig. 16 is described next.

It should be noted that a signal with a phase opposite the phase of the signal applied to the clock terminal 802 is always applied to the opposite phase clock terminal 803. Only the signal applied to the clock terminal 802 is therefore considered below, and is accordingly referred to as the clock signal. When the clock signal is low, P-channel MOS transistor 810 and N-channel MOS transistor 812 are on, and P-channel MOS transistor 818 and N-channel MOS transistor 819 are off. When a high level signal is then applied to the data input terminal 801, P-channel MOS transistor 808 switches off, N-channel MOS transistor 814 switches on, and node 811 is discharged low. When a low level signal is applied to the data input terminal 801, P-channel MOS transistor 808 switches on, N-channel MOS transistor 814 switches off, and node 811 is discharged high. The data output terminal 805 is dynamic, and holds the state at which it is set when the clock signal is high.

When the clock signal then goes high, P-channel MOS transistor 810 and N-channel MOS transistor 812 switch off, and P-channel MOS transistor 818 and N-channel MOS transistor 819 switch on. If node 811 is high, P-channel MOS transistor 816 switches off, N-channel MOS transistor 821 switches on, and the data output terminal 805 is discharged low. If node 811 is low, P-channel MOS transistor 816 switches on, N-channel MOS transistor 821 switches off, and the data output terminal 805 is discharged high.

The level of node 811 is thus held statically by the latch circuit comprising inverters 822 and 823, is not lost when the clock signal stops, and the value stored when the clock signal was low is held irrespective of the signal applied to the data input terminal 801.

When the clock signal then goes low from high, writing to node 811 by inverter 807 and the holding operation of inverter 823 conflict. To prevent this problem, it is necessary to lower the drive capacity of inverter 823. This is accomplished by using step-up circuit 830 to lower the effective power supply voltage during operation.

Therefore, even if the gate width and gate length of the transistors in inverter 823 are the same as those of the transistors used in other circuit components such as inverters 807, 815, 822 and other circuit blocks, the operating conditions required for a holding circuit can be met. Power consumption can therefore be reduced because transistors having the smallest possible gate width can be used, and a static latch circuit according to the present invention can be used in applications where all gate lengths must be the same, such as in a gate array.

It should be noted that while only statically holding the node 811 is described above, the dynamic data output terminal 805 can also be held statically by appropriately applying the holding circuit according to the above-described embodiment or any of the preceding embodiments of the present invention.

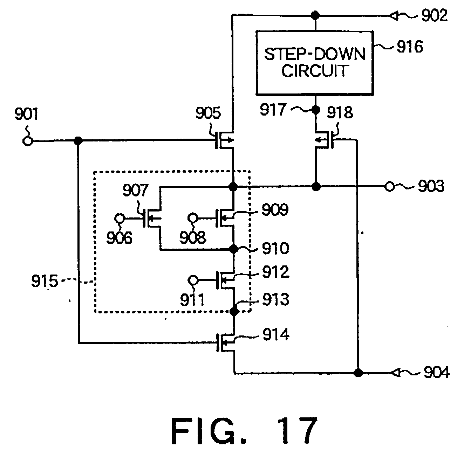

A static logic circuit according to a ninth embodiment of the present invention is described next with reference to Fig. 17. A static logic circuit according to this embodiment as shown in Fig. 17 is achieved by adding a P-channel MOS transistor 918 to a logic circuit comprising a P-channel MOS transistor 905, N-channel MOS transistor 914, and logic operator 915 comprising N-channel MOS transistors 912, 907, and 909. The source of P-channel MOS transistor 905 is connected to high side power supply terminal 902, the drain to data output terminal 903, and the gate to clock terminal 901. The source of N-channel MOS transistor 914 is connected to low side power supply terminal 904, the drain to node 913, and the gate to clock terminal 901. The source of N-channel MOS transistor 912 is connected to node 913, the drain to node 910, and the gate to a first data input terminal 911. The source of N-channel MOS transistor 907 is connected to node 910, the drain to data output terminal 903, and the gate to a second data input terminal 906. The source of N-channel MOS transistor 909 is connected to node 910, the drain to data output terminal 903, and the gate to a third data input terminal 908. The source of P-channel MOS transistor 918 is connected through step-down circuit 916 to the high side power supply terminal 902, the drain is connected to data output terminal 903, and the gate to low side power supply terminal 904.

The operation of a static logic circuit according to the present invention as shown in Fig. 17 is described next. It should be noted that the signal applied to the clock terminal 901 is referred to below as the clock signal. When the clock signal is low, P-channel MOS transistor 905 is on, N-channel MOS transistor 914 is off, and the data output terminal 903 is charged high.

When the clock signal then goes high, P-channel MOS transistor 905 switches off, and N-channel MOS transistor 914 switches on. If at this time at least one of N-channel MOS transistors 907 and 909 is on and N-channel MOS transistor 913 is also on, the data output terminal 903 is discharged to a low level. Because the gate of P-channel MOS transistor 918 is connected to the low side power supply terminal 904 and is always on, a dc current path is formed at this time in sequence from high side power supply terminal 902, step-down circuit 916, P-channel MOS transistor 918, the N-channel MOS transistor group forming the logic operator 915, N-channel MOS transistor 914, and low side power supply terminal 904. As with a static latch circuit described above, if the effective supply voltage is lowered using the step-down circuit 916, and the on resistance of the P-channel MOS transistor 918 is increased, the potential rises slightly from the low side potential, but the data output terminal 903 continues to output low.

In cases other than the above, the data output terminal 903 can be held high and does not change dynamically even when the clock signal stops because the P-channel MOS transistor 918 is always on. The static logic circuit shown in Fig. 17 enables a high level hold when the clock signal stops because a slight increase in the standby current is allowed when outputting low.

Therefore, even if the gate width and gate length of the transistors in the holding circuit (step-down circuit 916 and P-channel MOS transistor 918) are the same as those of the transistors used in other circuit components (such as P-channel MOS transistor 905, N-channel MOS transistor 914, the N-channel MOS transistor group of the logic operator 915, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

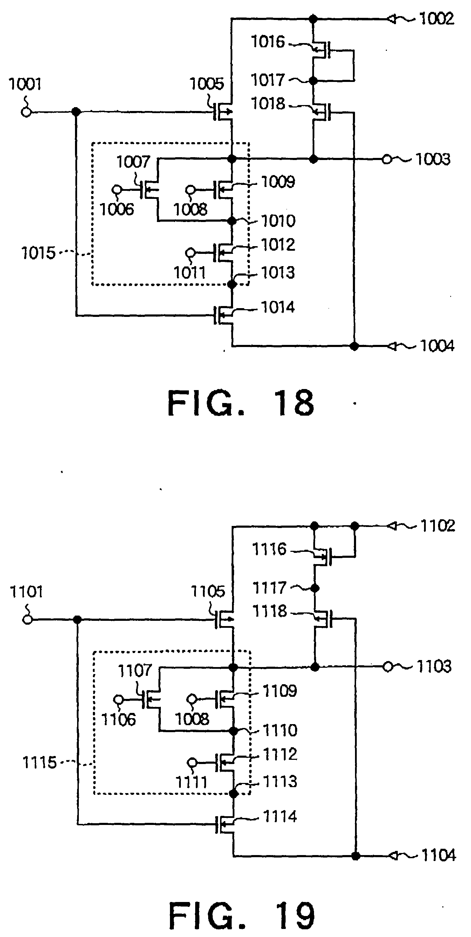

A static logic circuit according to a tenth embodiment of the present invention is described next with reference to Fig. 18 . A static logic circuit according to this embodiment as shown in Fig. 18 is achieved by adding a P-channel MOS transistor 1016 and a P-channel MOS transistor 1018 to a logic circuit comprising a P-channel MOS transistor 1005, N-channel MOS transistor 1014, and logic operator 1015 comprising N-channel MOS transistors 1012, 1007, and 1009.

The source of P-channel MOS transistor 1005 is connected to high side power supply terminal 1002, the drain to data output terminal 1003, and the gate to clock terminal 1001. The source of N-channel MOS transistor 1014 is connected to low side power supply terminal 1004, the drain to node 1013, and the gate to clock terminal 1001. The source of N-channel MOS transistor 1012 is connected to node 1013, the drain to node 1010, and the gate to a first data input terminal 1011. The source of N-channel MOS transistor 1007 is connected to node 1010, the drain to data output terminal 1003, and the gate to a second data input terminal 1006. The source of N-channel MOS transistor 1009 is connected to node 1010, the drain to data output terminal 1003, and the gate to a third data input terminal 1008. The source of P-channel MOS transistor 1016 is connected to the high side power supply terminal 1002, and the drain and gate to node 1017. The source of P-channel MOS transistor 1018 is connected to node 1017, the drain is connected to data output terminal 1003, and the gate to low side power supply terminal 1004.

The operation of a static logic circuit according to the present invention as shown in Fig. 18 is described next. It should be noted that the signal applied to the clock terminal 1001 is referred to below as the clock signal. When the clock signal is low, P-channel MOS transistor 1005 is on, N-channel MOS transistor 1014 is off, and the data output terminal 1003 is charged high.

When the clock signal then goes high, P-channel MOS transistor 1005 switches off, and N-channel MOS transistor 1014 switches on. If at this time at least one of N-channel MOS transistors 1007 and 1009 is on and N-channel MOS transistor 1012 is also on, the data output terminal 1003 is discharged to a low level. Because the gate of P-channel MOS transistor 1018 is connected to the low side power supply terminal 1004 and is always on, a dc current path is formed at this time in sequence from high side power supply terminal 1002, P-channel MOS transistor 1016, P-channel MOS transistor 1018, the N-channel MOS transistor group forming the logic operator 1015, N-channel MOS transistor 1014, and low side power supply terminal 1004. The effective supply voltage can be lowered by using the diode formed by P-channel MOS transistor 1016 forward biased from the high side power supply terminal 1002 to node 1017 as a step-down circuit. As a result, if the on resistance of the P-channel MOS transistor 1018 is increased, the potential rises slightly from the low side potential, but the data output terminal 1003 continues to output low.

In cases other than the above, the data output terminal 1003 can be held high and does not change dynamically even when the clock signal stops because the P-channel MOS transistor 1018 is always on. The static logic circuit shown in Fig. 18 enables a high level hold when the clock signal stops because a slight increase in the standby current is allowed when outputting low.

Therefore, even if the gate width and gate length of the transistors in the holding circuit (P-channel MOS transistor 1016 and P-channel MOS transistor 1018) are the same as those of the transistors used in other circuit components (such as P-channel MOS transistor 1005, N-channel MOS transistor 1014, the N-channel MOS transistor group of the logic operator 1015, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

A static logic circuit according to an eleventh embodiment of the present invention is described next with reference to Fig. 19. A static logic circuit according to this embodiment as shown in Fig. 19 is achieved by adding an N-channel MOS transistor 1116 and a P-channel MOS transistor 1118 to a logic circuit comprising a P-channel MOS transistor 1105, N-channel MOS transistor 1114, and logic operator 1115 comprising N-channel MOS transistors 1112, 1107, and 1109.

The source of P-channel MOS transistor 1105 is connected to high side power supply terminal 1102, the drain to data output terminal 1103, and the gate to clock terminal 1101. The source of N-channel MOS transistor 1114 is connected to low side power supply terminal 1104, the drain to node 1113, and the gate to clock terminal 1101. The source of N-channel MOS transistor 1112 is connected to node 1113, the drain to node 1110, and the gate to a first data input terminal 1111.

The source of N-channel MOS transistor 1107 is connected to node 1110, the drain to data output terminal 1103, and the gate to a second data input terminal 1106. The source of N-channel MOS transistor 1109 is connected to node 1110, the drain to data output terminal 1103, and the gate to a third data input terminal 1108. The drain and gate of N-channel MOS transistor 1116 are connected to the high side power supply terminal 1102, and the source to node 1117. The source of P-channel MOS transistor 1118 is connected to node 1117, the drain is connected to data output terminal 1103, and the gate to low side power supply terminal 1104.

The operation of a static logic circuit according to the present invention as shown in Fig. 19 is described next. It should be noted that the signal applied to the clock terminal 1101 is referred to below as the clock signal. When the clock signal is low, P-channel MOS transistor 1105 is on, N-channel MOS transistor 1114 is off, and the data output terminal 1103 is charged high.

When the clock signal then goes high, P-channel MOS transistor 1105 switches off, and N-channel MOS transistor 1114 switches on. If at this time at least one of N-channel MOS transistors 1107 and 1109 is on and N-channel MOS transistor 1112 is also on, the data output terminal 1103 is discharged to a low level. Because the gate of P-channel MOS transistor 1118 is connected to the low side power supply terminal 1104 and is always on, a dc current path is formed at this time in sequence from high side power supply terminal 1102, N-channel MOS transistor 1116, P-channel MOS transistor 1118, the N-channel MOS transistor group forming the logic operator 1115, N-channel MOS transistor 1114, and low side power supply terminal 1104. The effective supply voltage can be lowered by using the diode formed by N-channel MOS transistor 1116 forward biased from the high side power supply terminal 1102 to node 1117 as a step-down circuit. As a result, if the on resistance of the P-channel MOS transistor 1118 is increased, the potential rises slightly from the low side potential, but the data output terminal 1103 continues to output low.

In cases other than the above, the data output terminal 1103 can be held high and does not change dynamically even when the clock signal stops because the P-channel MOS transistor 1118 is always on. The static logic circuit shown in Fig. 19 enables a high level hold when the clock signal stops because a slight increase in the standby current is allowed when outputting low.

Therefore, even if the gate width and gate length of the transistors in the holding circuit (N-channel MOS transistor 1116 and P-channel MOS transistor 1118) are the same as those of the transistors used in other circuit components (such as P-channel MOS transistor 1105, N-channel MOS transistor 1114, the N-channel MOS transistor group of the logic operator 1115, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

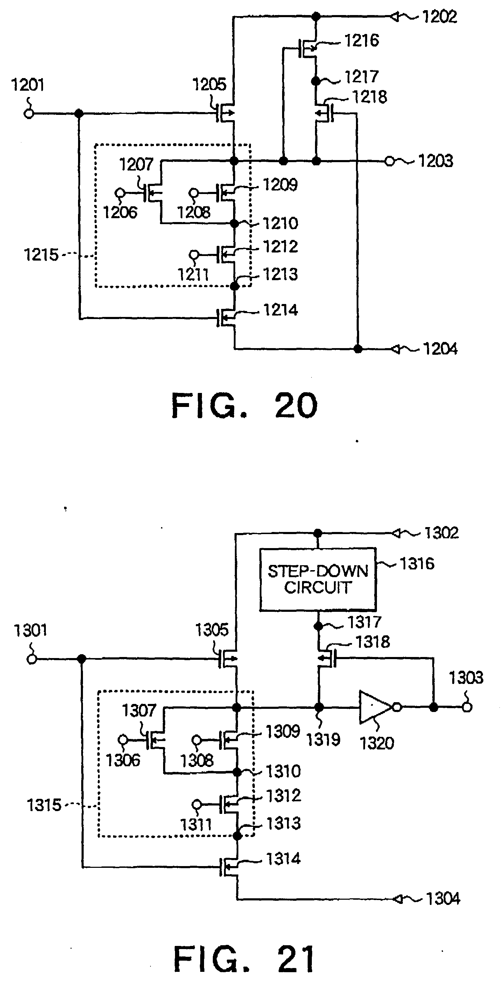

A static logic circuit according to a twelfth embodiment of the present invention is described next with reference to Fig. 20. A static logic circuit according to this embodiment as shown in Fig. 20 is achieved by adding a P-channel MOS transistor 1216 and a P-channel MOS transistor 1218 to a logic circuit comprising a P-channel MOS transistor 1205, N-channel MOS transistor 1214, and logic operator 1215 comprising N-channel MOS transistors 1212, 1207, and 1209.

The source of P-channel MOS transistor 1205 is connected to high side power supply terminal 1202, the drain to data output terminal 1203, and the gate to clock terminal 1201. The source of N-channel MOS transistor 1214 is connected to low side power supply terminal 1204, the drain to node 1213, and the gate to clock terminal 1201. The source Of N-channel MOS transistor 1212 is connected to node 1213, the drain to node 1210, and the gate to a first data input terminal 1211. The source of N-channel MOS transistor 1207 is connected to node 1210, the drain to data output terminal 1203, and the gate to a second data input terminal 1206. The source of N-channel MOS transistor 1209 is connected to node 1210, the drain to data output terminal 1203, and the gate to a third data input terminal 1208. The source of P-channel MOS transistor 1216 is connected to the high side power supply terminal 1202, the drain to node 1217, and the gate to data output terminal 1203. The source of P-channel MOS transistor 1218 is connected to node 1217, the drain is connected to data output terminal 1203, and the gate to low side power supply terminal 1204.

The operation of a static logic circuit according to the present invention as shown in Fig. 20 is described next. It should be noted that the signal applied to the clock terminal 1201 is referred to below as the clock signal. When the clock signal is low, P-channel MOS transistor 1205 is on, N-channel MOS transistor 1214 is off, and the data output terminal 1203 is charged high.

When the clock signal then goes high, P-channel MOS transistor 1205 switches off, and N-channel MOS transistor 1214 switches on. If at this time at least one of N-channel MOS transistors 1207 and 1209 is on and N-channel MOS transistor 1212 is also on, the data output terminal 1203 is discharged to a low level. Because the gate of P-channel MOS transistor 1218 is connected to the low side power supply terminal 1204 and is always on, a dc current path is formed at this time in sequence from high side power supply terminal 1202, P-channel MOS transistor 1216, P-channel MOS transistor 1218, the N-channel MOS transistor group forming the logic operator 1215, N-channel MOS transistor 1214, and low side power supply terminal 1204. In addition, because P-channel MOS transistor 1218 is always on, the gate of P-channel MOS transistor 1216 is electrically connected to the drain of P-channel MOS transistor 1216, and the P-channel MOS transistor 1216 operates as a diode type step-down circuit forward biased from the high side power supply terminal 1202 to node 1217. Because the effective supply voltage of P-channel MOS transistor 1218 drops, the on resistance increases. As a result, the potential rises slightly from the low side potential, but the data output terminal 1203 continues to output low.

In cases other than the above, the data output terminal 1203 can be held high and does not change dynamically even when the clock signal stops because the P-channel MOS transistor 1218 is always on. The static logic circuit shown in Fig. 20 enables a high level hold when the clock signal stops because a slight increase in the standby current is allowed when outputting low.

Therefore, even if the gate width and gate length of the transistors in the holding circuit (P-channel MOS transistors 1216 and 1218) are the same as those of the transistors used in other circuit components (such as P-channel MOS transistor 1205, N-channel MOS transistor 1214, the N-channel MOS transistor group of the logic operator 1215, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

A static logic circuit according to a thirteenth embodiment of the present invention is described next with reference to Fig. 21. A static logic circuit according to this embodiment as shown in Fig. 21 is achieved by adding a P-channel MOS transistor 1318 to a logic circuit comprising a P-channel MOS transistor 1305, N-channel MOS transistor 1314, inverter 1320, and logic operator 1315 comprising N-channel MOS transistors 1312, 1307, and 1309.

The source of P-channel MOS transistor 1305 is connected to high side power supply terminal 1302, the drain to node 1319, and the gate to clock terminal 1301. The source of N-channel MOS transistor 1314 is connected to low side power supply terminal 1304, the drain to node 1313, and the gate to clock terminal 1301.

The output terminal of the inverter 1320 is connected to data output terminal 1303 and the input terminal to node 1319.

The source of N-channel MOS transistor 1312 is connected to node 1313, the drain to node 1310, and the gate to a first data input terminal 1311. The source of N-channel MOS transistor 1307 is connected to node 1310, the drain to node 1319, and the gate to a second data input terminal 1306. The source of N-channel MOS transistor 1309 is connected to node 1310, the drain to node 1319, and the gate to a third data input terminal 1308. The source of P-channel MOS transistor 1318 is connected through step-down circuit 1316 to the high side power supply terminal 1302, the drain is connected to node 1319, and the gate to data output terminal 1303.

The operation of a static logic circuit according to the present invention as shown in Fig. 21 is described next. It should be noted that the signal applied to the clock terminal 1301 is referred to below as the clock signal.

When the clock signal is low, P-channel MOS transistor 1305 is on, N-channel MOS transistor 1314 is off, node 1319 is charged high, and the inverter 1320 thus outputs low to the data output terminal 1303. P-channel MOS transistor 1318 is on at this time.

When the clock signal then goes high, P-channel MOS transistor 1305 switches off, and N-channel MOS transistor 1314 switches on. If at this time at least one of N-channel MOS transistors 1307 and 1309 is on and N-channel MOS transistor 1312 is also on, node 1319 is discharged to a low level, the inverter 1320 outputs high to the data output terminal 1303, and the P-channel MOS transistor 1318 switches off. In all other cases, the node 1319 is held high, the inverter 1320 outputs low to the data output terminal 1303, and P-channel MOS transistor 1318 switches on. Node 1319 therefore does not change dynamically, and can be statically held high.

When the clock signal goes high from low in this circuit and the charge stored to node 1319 is discharged, the discharge operation through the N-channel MOS transistor group of the logic operator 1315 and N-channel MOS transistor 1314, and the holding operation of P-channel MOS transistor 1318 conflict. Problems such as discharging being blocked or delayed, and an increase in power consumption can thus occur. To prevent this problem, it is necessary to lower the drive capacity of P-channel MOS transistor 1318, which can be accomplished by lowering the effective power supply voltage during operation using step-down circuit 1316.

Therefore, even if the gate width and gate length of the transistor forming the step-down circuit 1316 and the P-channel MOS transistor 1318 are the same as those of the transistors used in other circuit components (such as P-channel MOS transistor 1305, N-channel MOS transistor 1314, the N-channel MOS transistor group of the logic operator 1315, inverter 1320, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

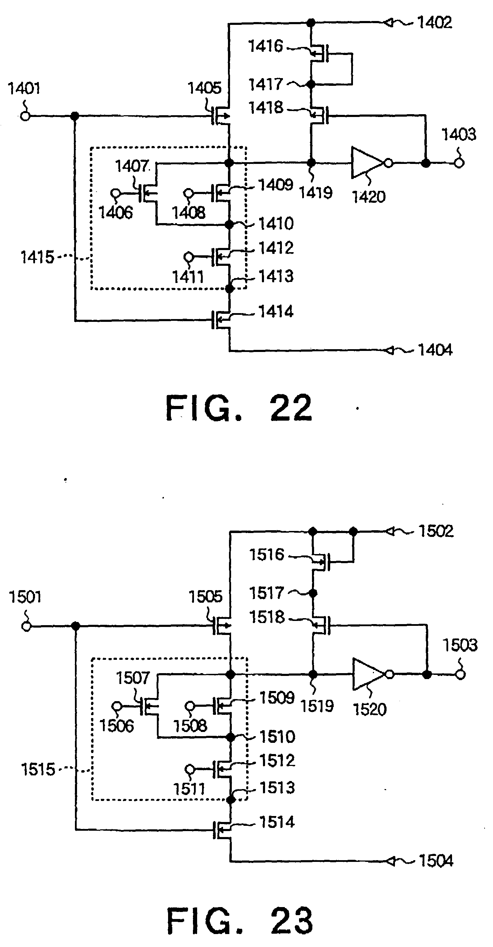

A static logic circuit according to a fourteenth embodiment of the present invention is described next with reference to Fig. 22. A static logic circuit according to this embodiment as shown in Fig. 22 is achieved by adding a P-channel MOS transistor 1416 and a P-channel MOS transistor 1418 to a logic circuit comprising a P-channel MOS transistor 1405, N-channel MOS transistor 1414, inverter 1420, and logic operator 1415 comprising N-channel MOS transistors 1412, 1407, and 1409.

The source of P-channel MOS transistor 1405 is connected to high side power supply terminal 1402, the drain to node 1419, and the gate to clock terminal 1401. The source of N-channel MOS transistor 1414 is connected to low side power supply terminal 1404, the drain to node 1413, and the gate to clock terminal 1401. The input terminal of the inverter 1420 is connected to node 1419, and the output terminal is connected to data output terminal 1403. The source of N-channel MOS transistor 1412 is connected to node 1413, the drain to node 1410, and the gate to a first data input terminal 1411. The source of N-channel MOS transistor 1407 is connected to node 1410, the drain to node 1419, and the gate to a second data input terminal 1406. The source of N-channel MOS transistor 1409 is connected to node 1410, the drain to node 1419, and the gate to a third data input terminal 1408. The source of P-channel MOS transistor 1416 is connected to the high side power supply terminal 1402, and the drain and gate are connected to node 1417. The source of P-channel MOS transistor 1418 is connected to node 1417, the drain is connected to node 1419, and the gate to data output terminal 1403.

The operation of a static logic circuit according to the present invention as shown in Fig. 22 is described next. It should be noted that the signal applied to the clock terminal 1401 is referred to below as the clock signal. When the clock signal is low, P-channel MOS transistor 1405 is on, N-channel MOS transistor 1414 is off, node 1419 is charged high, and the inverter 1420 thus outputs low to the data output terminal 1403. P-channel MOS transistor 1418 is on at this time.

When the clock signal then goes high, P-channel MOS transistor 1405 switches off, and N-channel MOS transistor 1414 switches on. If at this time at least one of N-channel MOS transistors 1407 and 1409 is on and N-channel MOS transistor 1412 is also on, and node 1419 is discharged to a low level. Then the inverter 1420 outputs high to the data output terminal 1403, and the P-channel MOS transistor 1418 switches off. In all other cases, the node 1419 is held high, and the inverter 1420 outputs low to the data output terminal 1403. Because P-channel MOS transistor 1418 switches on, node 1419 does not change dynamically and can be statically held high.

When the clock signal goes high from low in this circuit and the charge stored to node 1419 is discharged, the discharge operation through the N-channel MOS transistor group of the logic operator 1415 and N-channel MOS transistor 1414, and the holding operation of P-channel MOS transistor 1418 conflict. Problems such as discharging being blocked or delayed, and an increase in power consumption can thus occur. To prevent this problem, it is necessary to lower the drive capacity of P-channel MOS transistor 1418. This can be accomplished in the present embodiment by lowering the effective power supply voltage during operation using as a step-down circuit the diode formed by P-channel MOS transistor 1416 forward biased from the high side power supply terminal 1402 to node 1417.

Therefore, even if the gate width and gate length of P-channel MOS transistors 1416 and 1418 are the same as those of the transistors used in other circuit components (such as P-channel MOS transistor 1405, N-channel MOS transistor 1414, the N-channel MOS transistor group of the logic operator 1415, inverter 1420, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

A static logic circuit according to a fifteenth embodiment of the present invention is described next with reference to Fig. 23. A static logic circuit according to this embodiment as shown in Fig. 23 is achieved by adding an N-channel MOS transistor 1516 and a P-channel MOS transistor 1518 to a logic circuit comprising a P-channel MOS transistor 1505, N-channel MOS transistor 1514, inverter 1520, and logic operator 1515 comprising N-channel MOS transistors 1512, 1507, and 1509.

The source of P-channel MOS transistor 1505 is connected to high side power supply terminal 1502, the drain to node 1519, and the gate to clock terminal 1501. The source of N-channel MOS transistor 1514 is connected to low side power supply terminal 1504, the drain to node 1513, and the gate to clock terminal 1501. The input terminal of the inverter 1520 is connected to node 1519, and the output terminal is connected to data output terminal 1503. The source of N-channel MOS transistor 1512 is connected to node 1513, the drain to node 1510, and the gate to a first data input terminal 1511. The source of N-channel MOS transistor 1507 is connected to node 1510, the drain to node 1519, and the gate to a second data input terminal 1506. The source of N-channel MOS transistor 1509 is connected to node 1510, the drain to node 1519, and the gate to a third data input terminal 1508. The drain and gate of N-channel MOS transistor 1516 are connected to the high side power supply terminal 1502, and the source is connected to node 1517. The source of P-channel MOS transistor 1518 is connected to node 1517, the drain is connected to node 1519, and the gate to data output terminal 1503.

The operation of a static logic circuit according to the present invention as shown in Fig. 23 is described next. It should be noted that the signal applied to the clock terminal 1501 is referred to below as the clock signal. When the clock signal is low, P-channel MOS transistor 1505 is on, and N-channel MOS transistor 1514 is off. Node 1519 is then charged high, and the inverter 1520 thus outputs low to the data output terminal 1503. P-channel MOS transistor 1518 is on at this time.

When the clock signal then goes high, P-channel MOS transistor 1505 switches off, and N-channel MOS transistor 1514 switches on. If at this time at least one of N-channel MOS transistors 1507 and 1509 is on and N-channel MOS transistor 1512 is also on, node 1519 is discharged to a low level. Then the inverter 1520 outputs high to the data output terminal 1503, and the P-channel MOS transistor 1518 switches off. In all other cases, the node 1519 is held high, and the inverter 1520 outputs low to the data output terminal 1503. Because P-channel MOS transistor 1518 switches on, node 1519 does not change dynamically and can be statically held high.

When the clock signal goes high from low in this circuit and the charge stored to node 1519 is discharged, the discharge operation through the N-channel MOS transistor group of the logic operator 1515 and N-channel MOS transistor 1514, and the holding operation of P-channel MOS transistor 1518 conflict. Problems such as discharging being blocked or delayed, and an increase in power consumption can thus occur. To prevent this problem, it is necessary to lower the drive capacity of P-channel MOS transistor 1518. This can be accomplished in the present embodiment by lowering the effective power supply voltage during operation using as a step-down circuit the diode formed by N-channel MOS transistor 1516 forward biased from the high side power supply terminal 1502 to node 1517.

Therefore, even if the gate width and gate length of N-channel MOS transistor 1516 and P-channel MOS transistor 1518 are the same as those of the transistors used in other circuit components (such as P-channel MOS transistor 1505, N-channel MOS transistor 1514, the N-channel MOS transistor group of the logic operator 1515, inverter 1520, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

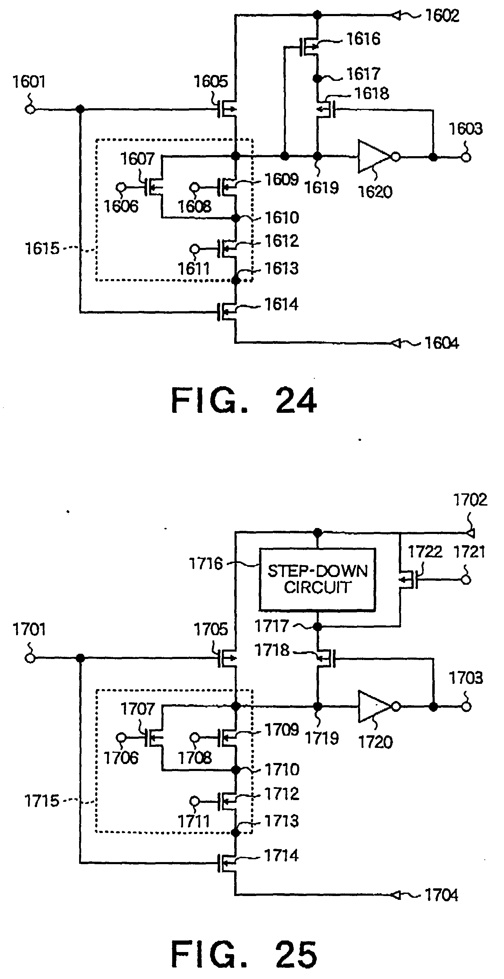

A static logic circuit according to a sixteenth embodiment of the present invention is described next with reference to Fig. 24. A static logic circuit according to this embodiment as shown in Fig. 24 is achieved by adding a P-channel MOS transistor 1616 and a P-channel MOS transistor 1618 to a logic circuit comprising a P-channel MOS transistor 1605, N-channel MOS transistor 1614, inverter 1620, and logic operator 1615 comprising N-channel MOS transistors 1612, 1607, and 1609.

The source of P-channel MOS transistor 1605 is connected to high side power supply terminal 1602, the drain to node 1619, and the gate to clock terminal 1601. The source of N-channel MOS transistor 1614 is connected to low side power supply terminal 1604, the drain to node 1613, and the gate to clock terminal 1601. The input terminal of the inverter 1620 is connected to node 1619, and the output terminal is connected to data output terminal 1603. The source of N-channel MOS transistor 1612 is connected to node 1613, the drain to node 1610, and the gate to a first data input terminal 1611. The source of N-channel MOS transistor 1607 is connected to node 1610, the drain to node 1619, and the gate to a second data input terminal 1606. The source of N-channel MOS transistor 1609 is connected to node 1610, the drain to node 1619, and the gate to a third data input terminal 1608. The source of P-channel MOS transistor 1616 is connected to the high side power supply terminal 1602, the drain is connected to node 1617, and the gate is connected to node 1619. The source of P-channel MOS transistor 1618 is connected to node 1617, the drain is connected to node 1619, and the gate to data output terminal 1603.

The operation of a static logic circuit according to the present invention as shown in Fig. 24 is described next. It should be noted that the signal applied to the clock terminal 1601 is referred to below as the clock signal.

When the clock signal is low, P-channel MOS transistor 1605 is on, and N-channel MOS transistor 1614 is off. Node 1619 is then charged high, and the inverter 1620 thus outputs low to the data output terminal 1603. P-channel MOS transistor 1618 is on at this time.

When the clock signal then goes high, P-channel MOS transistor 1605 switches off, and N-channel MOS transistor 1614 switches on. If at this time at least one of N-channel MOS transistors 1607 and 1609 is on and N-channel MOS transistor 1612 is also on, node 1619 is discharged to a low level, and the inverter 1620 outputs high to the data output terminal 1603. In all other cases, the node 1619 is held high, the inverter 1620 outputs low to the data output terminal 1603, and P-channel MOS transistor 1618 switches on. As a result, node 1619 does not change dynamically, and can be statically held high.

When the clock signal goes high from low in this circuit and the charge stored to node 1619 is discharged, the discharge operation through the N-channel MOS transistor group of the logic operator 1615 and N-channel MOS transistor 1614, and the holding operation of P-channel MOS transistor 1618 conflict. Problems such as discharging being blocked or delayed, and an increase in power consumption can thus occur. To prevent this problem, it is necessary to lower the drive capacity of P-channel MOS transistor 1618. Therefore, when it is necessary to hold the value in node 1619, P-channel MOS transistor 1618 is switched on, the gate and drain are electrically connected, and the diode formed by N-channel MOS transistor 1616 forward biased from the high side power supply terminal 1602 to node 1617 is driven as a diode type step-down circuit to lower the effective power supply voltage during operation.

Therefore, even if the gate width and gate length of P-channel MOS transistor 1616 and P-channel MOS transistor 1618 are the same as those of the transistors used in other circuit components (such as P-channel MOS transistor 1605, N-channel MOS transistor 1614, the N-channel MOS transistor group of the logic operator 1615, inverter 1620, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

A static logic circuit according to a seventeenth embodiment of the present invention is described next with reference to Fig. 25. A static logic circuit according to this embodiment as shown in Fig. 25 is achieved by adding a P-channel MOS transistor 1718 and a P-channel MOS transistor 1722 to a logic circuit comprising a P-channel MOS transistor 1705, N-channel MOS transistor 1714, inverter 1720, and logic operator 1715 comprising N-channel MOS transistors 1712, 1707, and 1709.

The source of P-channel MOS transistor 1705 is connected to high side power supply terminal 1702, the drain to node 1719, and the gate to clock terminal 1701. The source of N-channel MOS transistor 1714 is connected to low side power supply terminal 1704, the drain to node 1713, and the gate to clock terminal 1701. The input terminal of the inverter 1720 is connected to node 1719, and the output terminal is connected to data output terminal 1703. The source of N-channel MOS transistor 1712 is connected to node 1713, the drain to node 1710, and the gate to a first data input terminal 1711. The source of N-channel MOB transistor 1707 is connected to node 1710, the drain to node 1719, and the gate to a second data input terminal 1706. The source of N-channel MOS transistor 1709 is connected to node 1710, the drain to node 1719, and the gate to a third data input terminal 1708. The source of P-channel MOS transistor 1718 is connected through a step-down circuit 1716 to the high side power supply terminal 1702, the drain is connected to node 1719, and the gate is connected to the data output terminal 1703. The source of P-channel MOS transistor 1722 is connected to the high side power supply terminal 1702, the drain to node 1717, and the gate to a standby control terminal 1721.

The operation of a static logic circuit according to the present invention as shown in Fig. 25 is described next. It should be noted that the signal applied to the clock terminal 1701 is referred to below as the clock signal, and the signal applied to the standby control terminal 1721 is referred to as a standby control signal. When the standby control signal is high, P-channel MOS transistor 1722 is off, and circuit operation can therefore be discussed without considering this transistor. The logic operation of the logic circuit shown in Fig. 25 is the same as that of the logic circuit shown in Fig. 21.

When the clock signal stops, the node corresponding to node 1719 in the logic circuits shown in Fig. 21 to Fig. 24 settles to a dc level of several hundred millivolts below the high side potential. As a result, a slight standby current is consumed by the inverter corresponding to inverter 1720. P-channel MOS transistor 1721 is switched on by driving the standby control signal low when the clock signal stops, and node 1719 settles to the high side level. The effects achieved by the logic circuits shown in Fig. 21 to Fig. 24 can thus be achieved without increasing the standby power of the inverter 1720.

Therefore, even if the gate width and gate length of the transistors in the holding circuit (step-down circuit 1716 and P-channel MOS transistor 1718) are the same as those of the transistors used in other circuit components (such as P-channel MOS transistor 1705, N-channel MOS transistor 1714, the N-channel MOS transistor group of the logic operator 1715, inverter 1720, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

It should be further noted that any of the step-down circuits shown in Fig. 22 to Fig. 24 can be used for the step-down circuit 1716 shown in Fig. 25.

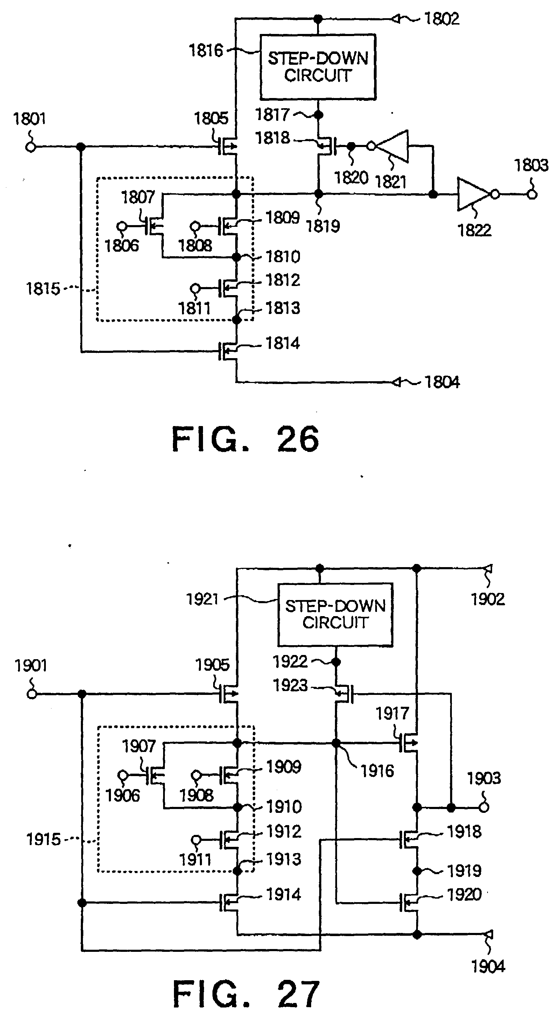

A static logic circuit according to an eighteenth embodiment of the present invention is described next with reference to Fig. 26. A static logic circuit according to this embodiment as shown in Fig. 26 is achieved by adding an inverter 1821 and a P-channel MOS transistor 1818 to a logic circuit comprising a P-channel MOS transistor 1805, N-channel MOS transistor 1814, inverter 1822, and logic operator 1815 comprising N-channel MOS transistors 1812, 1807, and 1809.

The source of P-channel MOS transistor 1805 is connected to high side power supply terminal 1802, the drain to node 1819, and the gate to clock terminal 1801. The source of N-channel MOS transistor 1814 is connected to low side power supply terminal 1804, the drain to node 1813, and the gate to clock terminal 1801. The input terminal of the inverter 1822 is connected to node 1819, and the output terminal is connected to data output terminal 1803. The source of N-channel MOS transistor 1812 is connected to node 1813, the drain to node 1810, and the gate to a first data input terminal 1811. The source of N-channel MOS transistor 1807 is connected to node 1810, the drain to node 1819, and the gate to a second data input terminal 1806. The source of N-channel MOS transistor 1809 is connected to node 1810, the drain to node 1819, and the gate to a third data input terminal 1808. The input terminal of the inverter 1821 is connected to node 1819, and the output terminal is connected to node 1820. The source of P-channel MOS transistor 1818 is connected through a step-down circuit 1816 to the high side power supply terminal 1802, the drain is connected to node 1819, and the gate is connected to node 1820.

The operation of a static logic circuit according to the present invention as shown in Fig. 26 is described next. It should be noted that the signal applied to the clock terminal 1801 is referred to below as the clock signal. When the clock signal is low, P-channel MOS transistor 1805 is on, and N-channel MOS transistor 1814 is off. Node 1819 is then charged high, and the inverter 1822 thus outputs low to the data output terminal 1803. A low is also applied to node 1820, which is connected to node 1819 through inverter 1821, and P-channel MOS transistor 1818 turns on.

When the clock signal then goes high, P-channel MOS transistor 1805 switches off, and N-channel MOS transistor 1814 switches on. If at this time at least one of N-channel MOS transistors 1807 and 1809 is on and N-channel MOS transistor 1812 is also on, node 1819 is discharged to a low level. Inverter 1822 then outputs high to the data output terminal 1803, and inverter 1821 outputs low to node 1820, causing P-channel MOS transistor 1818 to turn off. In all other cases, the node 1819 is held high, and the inverter 1822 outputs low to the data output terminal 1803. P-channel MOS transistor 1818 also turns on because node 1820 goes low. As a result, node 1819 does not change dynamically, and can be statically held high.

When the clock signal goes high from low in this circuit and the charge stored to node 1819 is discharged, the discharge operation through the N-channel MOS transistor group of the logic operator 1815 and N-channel MOS transistor 1814, and the holding operation of P-channel MOS transistor 1818 conflict. Problems such as discharging being blocked or delayed, and an increase in power consumption can thus occur. To prevent this problem, it is necessary to lower the drive capacity of P-channel MOS transistor 1818, which is accomplished in the present embodiment by lowering the effective power supply voltage during operation using step-down circuit 1816.

Therefore, even if the gate width and gate length of step-down circuit 1816 and P-channel MOS transistor 1818 are the same as those of the transistors used in other circuit components (such as P-channel MOS transistor 1805, N-channel MOS transistor 1814, the N-channel MOS transistor group of the logic operator 1815, inverters 1821 and 1822, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

Operation of this logic circuit is essentially the same as the operation of the logic circuit shown in Fig. 21. Charging and discharging take time in the logic circuit shown in Fig. 21 when the load connected to the output terminal 1303 is large, and conflict results between the desired circuit operation and a holding circuit using output signal feedback. Problems such as a drop in the operating speed and an increase in power consumption can thus result. This problem is avoided in a logic circuit according to the present embodiment by separating the inverter 1822 for driving the output terminal 1803 load and the inverter 1821 for driving the holding circuit, thereby preventing a delay changing the signal applied to the data output terminal 1803 when the output load is high from affecting the desired circuit operation. As a result, the present embodiment has the further benefit of preventing a drop in operating speed and an increase in power consumption. It should be further noted that any of the step-down circuits shown in Fig. 22 to Fig. 24 can be used for the step-down circuit 1816 shown in Fig. 26.

A static logic circuit according to a nineteenth embodiment of the present invention is described next with reference to Fig. 27. A static logic circuit according to this embodiment as shown in Fig. 27 is achieved by adding a P-channel MOS transistor 1917, N-channel MOS transistor 1920, N-channel MOS transistor 1918, and P-channel MOS transistor 1923 to a logic circuit comprising a P-channel MOS transistor 1905, N-channel MOS transistor 1914, and logic operator 1915 comprising N-channel MOS transistors 1912, 1907, and 1909.

The source of P-channel MOS transistor 1905 is connected to high side power supply terminal 1902, the drain to node 1916, and the gate to clock terminal 1901. The source of N-channel MOS transistor 1914 is connected to low side power supply terminal 1904, the drain to node 1913, and the gate to clock terminal 1901. The source of N-channel MOS transistor 1912 is connected to node 1913, the drain to node 1910, and the gate to a first data input terminal 1911. The source of N-channel MOS transistor 1907 is connected to node 1910, the drain to node 1916, and the gate to a second data input terminal 1906. The source of N-channel MOS transistor 1909 is connected to node 1910, the drain to node 1916, and the gate to a third data input terminal 1908. The source of P-channel MOS transistor 1917 is connected to the high side power supply terminal 1902, the drain to the data output terminal 1903, and the gate to node 1916. The source of N-channel MOS transistor 1920 is connected to low side power supply terminal 1904, the drain to node 1919, and the gate to node 1916. The source of N-channel MOS transistor 1918 is connected to node 1919, the drain to data output terminal 1903, and the gate to clock terminal 1901. The source of P-channel MOS transistor 1923 is connected through step-down circuit 1921 to the high side power supply terminal 1902, the drain to node 1916, and the gate to the data output terminal 1903.

The operation of a static logic circuit according to the present invention as shown in Fig. 27 is described next. It should be noted that the signal applied to the clock terminal 1901 is referred to below as the clock signal.

When the clock signal is low, P-channel MOS transistor 1905 is on, and N-channel MOS transistors 1914 and 1918 are off. Node 1916 is then charged high, P-channel MOS transistor 1917 turns off, and N-channel MOS transistor 1920 turns on. The data output terminal 1903 is set to a dynamic hold state.

When the clock signal then goes high from low, P-channel MOS transistor 1905 switches off, and N-channel MOS transistor 1914 and 1918 switches on. If at this time at least one of N-channel MOS transistors 1907 and 1909 is on and N-channel MOS transistor 1912 is also on, node 1916 is discharged to a low level; otherwise node 1916 holds high.

When node 1916 is discharged to the low level, P-channel MOS transistor 1917 turns on and N-channel MOS transistor 1920 turns off. The data output terminal thus outputs high. If the node 1916 holds high, P-channel MOS transistor 1917 turns off and N-channel MOS transistor 1920 turns on. Because the data output terminal 1903 then outputs low and this signal is also applied to P-channel MOS transistor 1923, P-channel MOS transistor 1923 turns on. Node 1916 therefore does not change dynamically, and can be held statically high.

When the clock signal goes high from low in this circuit and the charge stored to node 1916 is discharged, the discharge operation through the N-channel MOS transistor group of the logic operator 1915 and N-channel MOS transistor 1914, and the holding operation of P-channel MOS transistor 1923 conflict. Problems such as discharging being blocked or delayed, and an increase in power consumption can thus occur. To prevent this problem, it is necessary to lower the drive capacity of P-channel MOS transistor 1923, which is accomplished in the present embodiment by lowering the effective power supply voltage during operation using step-down circuit 1921.

Therefore, even if the gate width and gate length of step-down circuit 1921 and P-channel MOS transistor 1923 are the same as those of the transistors used in other circuit components (such as P-channel MOS transistors 1905 and 1917, N-channel MOS transistors 1914, 1918, 1920, the N-channel MOS transistor group of the logic operator 1915, and other circuit blocks), the conditions required for a holding circuit can be met. Power consumption can therefore be reduced because transistors having the smallest possible gate width can be used, and a static logic circuit according to the present invention can be used in applications where all gate lengths must be the same, such as in a gate array.

It should be further noted that any of the step-down circuits shown in Fig. 14 to Fig. 16 can be used for the step-down circuit 1921 shown in Fig. 27.

It will also be obvious to one with ordinary skill in the related art that the effects described above can also be achieved by means of circuits in which the P-channel MOS transistors and N-channel MOS transistors, and high side power supply terminals and low side power supply terminals, are interchanged, and the step-down circuits are replaced with step-up circuits, in the circuits shown in Figs. 17 to 27.

As described above, problems can arise due to a conflict between write operations and hold operations when the clock signal changes in a static latch circuit or static logic circuit according to the present invention. These problems are resolved, however, by using a step-down circuit and step-up circuit to lower the effective supply voltage during operation as a means of decreasing the drive capacity in parts associated with the static holding function of the latch and logic circuits.

In addition, the conditions required for holding circuit operation can be sufficiently achieved even if the gate width and gate length of transistors in the parts associated with the static holding function are the same as those of the transistors used in other circuit components.

Power consumption can therefore be reduced because transistors having the smallest possible gate width can be used, and a static logic circuit or static latch circuit according to the present invention can be used in applications where all gate lengths must be the same, such as in a gate array.

Although the present invention has been described in connection with the preferred embodiments thereof with reference to the accompanying drawings, it is to be noted that various changes and modifications will be apparent to those skilled in the art. Such changes and modifications are to be understood as included within the scope of the present invention as defined by the appended claims, unless they depart therefrom.

## Claims

1. A static latch circuit having a control terminal,
a data input terminal,
a data output terminal,
a first power supply terminal,
a second power supply terminal,
a switching means controlled by the control terminal and disposed between the data input terminal and a first node, and
a latch circuit having a first inverter comprising a first first-conductive-type MOS transistor and a first second-conductive-type MOS transistor,
wherein the source of the first first-conductive-type MOS transistor is connected to the first power supply terminal,the drain to the data output terminal, and the gate to the first node, and
the source of the first second-conductive-type MOS transistor is connected to the second power supply terminal, the drain to the data output terminal, and the gate to the first node,
said static latch circuit comprising added to the latch circuit:
a second inverter comprising a second first-conductive type MOS transistor and a second second-conductive type MOS transistor,
wherein the drain of the second first-conductive-type MOS transistor is connected to the first node, the gate is connected to the data output terminal, and the source is connected to a second node, which is connected through a first voltage conversion circuit to the first power supply terminal, and
the drain of the second second-conductive-type MOS transistor is connected to the first node, the gate is connected to the data output terminal, and the source is connected to a third node, which is connected through a second voltage conversion circuit to the second power supply terminal.

2. The static latch circuit as set forth in claim 1, wherein the first voltage conversion circuit comprises a third first-conductive-type MOS transistor of which the source is connected to the first power supply terminal, and the drain and gate are connected to the second node; and
the second voltage conversion circuit comprises a third second-conductive-type MOS transistor of which the source is connected to the second power supply terminal, and the drain and gate are connected to the third node.

3. The static latch circuit as set forth in claim 1, wherein the first voltage conversion circuit comprises a third second-conductive-type MOS transistor of which the drain and gate are connected to the first power supply terminal, and the source is connected to the second node; and
the second voltage conversion circuit comprises a third first-conductive-type MOS transistor of which the drain and gate are connected the second power supply terminal, and the source is connected to the third node.

4. The static latch circuit as set forth in claim 1, wherein the first voltage conversion circuit comprises a third first-conductive-type MOS transistor of which the source is connected to the first power supply terminal, the drain is connected to the second node, and the gate is connected to the first node, and
the second voltage conversion circuit comprises a third second-conductive-type MOS transistor of which the source is connected to the second power supply terminal, the drain is connected to the third node, and the gate is connected to the first node.

5. The static latch circuit as set forth in claim 1, further comprising:
a second control terminal;
a third control terminal where a signal of which the phase is opposite the phase of a control signal input to the second control terminal is input to the third control terminal;
a third first-conductive-type MOS transistor of which the source is connected to the first power supply terminal, the drain is connected to the second node, and the gate is connected to the second control terminal; and
a third second-conductive-type MOS transistor of which the source is connected to the second power supply terminal, the drain is connected to the third node, and the gate is connected to the third control terminal.

6. A static latch circuit having a control terminal,
a first data input terminal,
a second data input terminal,
a first data output terminal,
a second data output terminal,
a first power supply terminal,
a second power supply terminal,
a first switching means controlled by the control terminal and disposed between the first data input terminal and a first node,
a second switching means disposed between the second data input terminal and a second node, and
a latch circuit having a first inverter and a second inverter,
said first inverter comprising a first first-conductive-type MOS transistor of which the source is connected to the first power supply terminal, the drain is connected to the first data output terminal, and the gate is connected to the first node, and
a first second-conductive-type MOS transistor of which the source is connected to the second power supply terminal, the drain is connected to the first data output terminal, and the gate is connected to the first node; and
said second inverter comprising a second first-conductive-type MOS transistor of which the source is connected to the first power supply terminal, the drain is connected to the second data output terminal, and the gate is connected to the second node, and
a second second-conductive-type MOS transistor of which the source is connected to the second power supply terminal, the drain is connected to the second data output terminal, and the gate is connected to the second node;
said static latch circuit comprising added to the latch circuit:
a third inverter comprising a third first-conductive-type MOS transistor of which the drain is connected to the second node, the gate is connected to the first node, and the source is connected to a third node, which is connected through a first first-type voltage conversion circuit to the first power supply terminal, and
a third second-conductive-type MOS transistor of which the drain is connected to the second node, the gate is connected to the first node, and the source is connected to a fourth node, which is connected through a first second-type voltage conversion circuit to the second power supply terminal; and
a fourth inverter comprising a fourth first-conductive-type MOS transistor of which the drain is connected to the first node, the gate is connected to the second node, and the source is connected to a fifth node, which is connected through a second first-type voltage conversion circuit to the first power supply terminal, and
a fourth second-conductive-type MOS transistor of which the drain is connected to the first node, the gate is connected to the second node, and the source is connected to a sixth node, which is connected through a second second-type voltage conversion circuit to the second power supply terminal.

7. A static latch circuit having a control terminal,
a first data input terminal,
a second data input terminal,
a first data output terminal,
a second data output terminal,
a first power supply terminal,
a second power supply terminal,
a first switching means controlled by the control terminal and disposed between the first data input terminal and a first node,
a second switching means disposed between the second data input terminal and a second node, and
a latch circuit having a first inverter and a second inverter,
said first inverter comprising a first first-conductive-type MOS transistor of which the source is connected to the first power supply terminal, the drain is connected to the first data output terminal, and the gate is connected to the first node, and
a first second-conductive-type MOS transistor of which the source is connected to the second power supply terminal, the drain is connected to the first data output terminal, and the gate is connected to the first node, and
said second inverter comprising a second first-conductive-type MOS transistor of which the source is connected to the first power supply terminal, the drain is connected to the second data output terminal, and the gate is connected to the second node, and
a second second-conductive-type MOS transistor of which the source is connected to the second power supply terminal, the drain is connected to the second data output terminal, and the gate is connected to the second node;
said static latch circuit comprising added to the latch circuit:
a third first-conductive-type MOS transistor of which the drain is connected to the second node, the gate is connected to the first node, and the source is connected to a third node, which is connected through a first voltage conversion circuit to the first power supply terminal;
a third second-conductive-type MOS transistor of which the drain is connected to the second node, the gate is connected to the first node, and the source is connected to a fourth node, which is connected through a second voltage conversion circuit to the second power supply terminal;
a fourth first-conductive-type MOS transistor of which the source is connected to the third node, the drain is connected to the first node, and the gate is connected to the second node; and
a fourth second-conductive-type MOS transistor of which the source is connected to the fourth node, the drain is connected to the first node, and the gate is connected to the second node.

8. A static latch circuit having a data input terminal,
a data output terminal,
a first power supply terminal,
a second power supply terminal,
a first control terminal,
a second control terminal where a signal of which the phase is opposite the phase of a control signal input to the first control terminal is input to the second control terminal,
a latch circuit having a first inverter and a second inverter,
said first inverter comprising a first first-conductive-type MOS transistor of which the source is connected to the first power supply terminal, the drain is connected to the first node, and the gate is connected to the data input terminal, and
a second first-conductive-type MOS transistor of which the source is connected to the first node, the drain is connected to the second node, and the gate is connected to the first control terminal, and
a first second-conductive-type MOS transistor of which the source is connected to the second power supply terminal, the drain is connected to the third node, and the gate is connected to the data input terminal, and
a second second-conductive-type MOS transistor of which the source is connected to the third node, the drain is connected to the second node, and the gate is connected to the second control terminal, and
said second inverter comprising a third first-conductive-type MOS transistor of which the source is connected to the first power supply terminal, the drain is connected to a fourth node, and the gate is connected to the second node, and
a fourth first-conductive-type MOS transistor of which the source is connected to the fourth node, the drain is connected to data output terminal, and the gate is connected to the second control terminal, and
a third second-conductive-type MOS transistor of which the source is connected to the second power supply terminal, the drain is connected to a fifth node, and the gate is connected to the second node, and
a fourth second-conductive-type MOS transistor of which the source is connected to the fifth node, the drain is connected to the data output terminal, and the gate is connected to the first control terminal;
said static latch circuit comprising added to the latch circuit:
a third inverter having a fifth first-conductive-type MOS transistor of which the source is connected to the first power supply terminal, the drain is connected to a sixth node, and the gate is connected to the second node, and
a fifth second-conductive-type MOS transistor of which the source is connected to the second power supply terminal, the drain is connected to a the sixth node, and the gate is connected to the second node; and
a fourth inverter comprising a sixth first-conductive-type MOS transistor of which the source is connected through a first voltage conversion circuit to the first power supply terminal, the drain is connected to the second node, and the gate is connected to the sixth node, and
a sixth second-conductive-type MOS transistor of which the source is connected through a second voltage conversion circuit to the second power supply terminal, the drain is connected to the second node, and the gate is connected to the sixth node.

9. A static logic circuit having a control terminal,
a data input terminal group,
a data output terminal,
a first power supply terminal,
a second power supply terminal, and
a logic circuit having a first first-conductive-type MOS transistor of which the source is connected to the first power supply terminal, the drain is connected to the data output terminal, and the gate is connected to the control terminal,
a first second-conductive-type MOS transistor of which the source is connected to the second power supply terminal, the drain is connected to a first node, and the gate is connected to the control terminal, and
a logic network disposed between the data output terminal and a first node, and comprising a plurality of second-conductive-type MOS transistors in a serial parallel arrangement whereby each gate is connected the data input terminal group,
said static logic circuit comprising added to the logic circuit:
a second first-conductive-type MOS transistor of which the drain is connected to the data output terminal, the gate is connected to the second power supply terminal, and the source is connected to a second node, which is connected through a voltage conversion circuit to the first power supply terminal.

10. The static logic circuit as set forth in claim 9, wherein the voltage conversion circuit comprises a third first-conductive-type MOS transistor of which the source is connected to the first power supply terminal, and the drain and gate are connected to the second node.

11. The static logic circuit as set forth in claim 9, wherein the voltage conversion circuit comprises a second second-conductive-type MOS transistor of which the drain and gate are connected to the first power supply terminal, and the source is connected to the second node.

12. The static logic circuit as set forth in claim 9, wherein the voltage conversion circuit comprises a third first-conductive-type MOS transistor of which the source is connected to the first power supply terminal, the drain is to the second node, and the gate is connected to the data output terminal.

13. A static logic circuit having a control terminal,
a data input terminal group,
a data output terminal,
a first power supply terminal,
a second power supply terminal, and
a logic circuit having a first first-conductive-type MOS transistor of which the source is connected to the first power supply terminal, the drain is connected to a first node, and the gate is connected to the control terminal,
a first second-conductive-type MOS transistor of which the source is connected to the second power supply terminal, the drain is connected to a second node, and the gate is connected to the control terminal, and
a logic network disposed between the first node and second node, and comprising a plurality of second-conductive-type MOS transistors in a serial parallel arrangement whereby each gate is connected the data input terminal group,
said static logic circuit comprising added to the logic circuit:
an inverter having a second first-conductive-type MOS transistor of which the source is connected to the first power supply terminal, the drain is connected to the data output terminal, and the gate is connected to the first node, and
a second second-conductive-type MOS transistor of which the source is connected to the second power supply terminal, the drain is connected to the data output terminal, and the gate is connected to the first node; and
a third first-conductive-type MOS transistor of which the drain is connected to the first node, the gate is connected to the data output terminal, and the source is connected to a third node, which is connected through a voltage conversion circuit to the first power supply terminal.

14. The static logic circuit as set forth in claim 13, wherein the voltage conversion circuit comprises a fourth first-conductive-type MOS transistor of which the source is connected to the first power supply terminal, and the drain and gate are connected to the third node.

15. The static logic circuit as set forth in claim 13, wherein the voltage conversion circuit comprises a third second-conductive-type MOS transistor of which the drain and gate are connected to the first power supply terminal, and the source is connected to the third node.

16. The static logic circuit as set forth in claim 13, wherein the voltage conversion circuit comprises a fourth first-conductive-type MOS transistor of which the source is connected to the first power supply terminal, the drain is connected to the third node, and the gate is connected to the first node.

17. The static logic circuit as set forth in claim 13, further comprising a fourth first-conductive-type MOS transistor of which the source is connected to the first power supply terminal, the drain is connected to the third node, and the gate is connected to the second control terminal.

18. A static logic circuit having a control terminal,
a data input terminal group,
a data output terminal,
a first power supply terminal,
a second power supply terminal, and
a logic circuit having a first first-conductive-type MOS transistor of which the source is connected to the first power supply terminal, the drain is connected to a first node, and the gate is connected to the control terminal,
a first second-conductive-type MOS transistor of which the source is connected to the second power supply terminal, the drain is connected to a second node, and the gate is connected to the control terminal, and
a logic network disposed between the first node and second node, and comprising a plurality of second-conductive-type MOS transistors in a serial parallel arrangement whereby each gate is connected the data input terminal group,
said static logic circuit comprising added to the logic circuit:
a first inverter having a second first-conductive-type MOS transistor of which the source is connected to the first power supply terminal, the drain is connected to the data output terminal, and the gate is connected to the first node, and
a second second-conductive-type MOS transistor of which the source is connected to the second power supply terminal, the drain is connected to the data output terminal, and the gate is connected to the first node;
a second inverter having a third first-conductive-type MOS transistor of which the source is connected to the first power supply terminal, the drain is connected to the third node, and the gate is connected to the first node, and
a third second-conductive-type MOS transistor of which the source is connected to the second power supply terminal, the drain is connected to the third node, and the gate is connected to the first node; and
a fourth first-conductive-type MOS transistor of which the drain is connected to the first node, the gate is connected to the third node, and the source is connected to a fourth node, which is connected through a voltage conversion circuit to the first power supply terminal.

19. A static logic circuit having a control terminal,
a data input terminal group,
a data output terminal,
a first power supply terminal,
a second power supply terminal, and
a logic circuit having a logic network disposed between a first node and a second node, and comprising
a first first-conductive-type MOS transistor of which the source is connected to the first power supply terminal, the drain is connected to the first node, and the gate is connected to the control terminal,
a first second-conductive-type MOS transistor of which the source is connected to the second power supply terminal, the drain is connected to the second node, and the gate is connected to the control terminal, and
a plurality of second-conductive-type MOS transistors in a serial parallel arrangement whereby each gate is connected the data input terminal group,
a second first-conductive-type MOS transistor of which the source is connected to the first power supply terminal, the drain is connected to the data output terminal, and the gate is connected to the first node,
a second second-conductive-type MOS transistor of which the source is connected to the second power supply terminal, the drain is connected to a third node, and the gate is connected to the first node, and
a third second-conductive-type MOS transistor of which the source is connected to a third node, the drain is connected to the data output terminal, and the gate is connected to the control terminal,
said static logic circuit comprising added to the logic circuit:
a third first-conductive-type MOS transistor of which the drain is connected to the first node, the gate is connected to the data output terminal, and the source is connected to a fourth node, which is connected through a voltage conversion circuit to the first power supply terminal.
